# EUROPÄISCHE PATENTSCHRIFT

(11) **EP 3 983 812 B1**
(45) Veröffentlichungstag und Bekanntmachung des Hinweises auf die Patenterteilung: **12.10.2022**
(21) Anmeldenummer: 21734080.1
(22) Anmeldetag: 15.06.2021
(51) Int. Cl.: G01R 31/52, G01R 19/10, H01F 38/30

(54) **SENSOR, SCHUTZSCHALTER, LADEKABEL UND LADESTATION**
SENSOR, CIRCUIT BREAKER, CHARGING CABLE AND CHARGING STATION
CAPTEUR, DISJONCTEUR, CÂBLE DE CHARGE ET STATION DE CHARGE

(30) Priorität: 22.06.2020 DE 102020116428
(43) Veröffentlichungstag der Anmeldung: 20.04.2022
(73) Patentinhaber: Magnetec GmbH, 63505 Langenselbold (DE)
(72) Erfinder: TOTH, David, 63517 Rodenbach (DE)
(74) Vertreter: Richly & Ritschel Patentanwälte PartG mbB
(86) Internationale Anmeldenummer: PCT/EP2021/066052
(87) Internationale Veröffentlichungsnummer: WO 2021/259699

(56) Entgegenhaltungen:
- EP-A2- 1 696 444
- DE-T2- 69 412 149
- US-A1- 2011 116 197
- US-A1- 2015 301 087

## Beschreibung

Die Erfindung betrifft einen Sensor, einen Schutzschalter, ein Ladekabel und eine Ladestation.

Sensoren zur Bestimmung von Differenzströmen sind in unterschiedlichen Bauformen und für unterschiedliche Applikationsfälle bekannt, insbesondere da Differenzströme für Personen eine Gefahr darstellen und Brände auslösen können.

Differenzströme treten auf, wenn ein elektrisches Versorgungsnetz, insbesondere ein Stromkreis innerhalb eines elektrischen Versorgungsnetzes, einen Defekt aufweist und dadurch innerhalb des elektrischen Versorgungsnetzes ein Fehlerstrom gegen Erde abfließen kann. Je nach Art und Aufbau des elektrischen Versorgungsnetzes können Differenzströme Wechselstromkomponenten und/oder Gleichstromkomponenten aufweisen.

Durch den stetigen Ausbau der Nutzung von erneuerbaren Energien, von Elektromobilität, von drehzahlvariablen elektrischen Maschinen und/oder dergleichen kommt es zu einer zahlenmäßigen Ausweitung von elektrischen Systemen, bei denen AC- und DC-Versorgungsnetze miteinander gekoppelt sind. Hierdurch kommt den Gleichstromkomponenten von Differenzströmen eine stetig steigende Bedeutung zu.

Typischerweise wird insbesondere bei der elektrischen Hausinstallation lediglich ein FI-Schutzschalter des Typs A verbaut, der das hausinterne elektrische Versorgungsnetz auf Differenzströme mit Wechselstromkomponenten überwachen kann, der jedoch Gleichstromfehler weder detektieren noch abschalten kann. Jedoch steigt auch in elektrischen Hausinstallationen der Einsatz von Gleichstromelementen, etwa beim Aufladen eines Elektrofahrzeugs oder durch den Betrieb von Solaranlagen.

Daher ist insbesondere beim Betrieb von Ladeinfrastruktur oder von Solarwechselrichtern oder dergleichen eine allstromsensitive Überwachung von Differenzströmen notwendig, die einen Differenzstromsensor beinhaltet, dessen ermittelter Messwert beim Überschreiten eines Grenzwertes zum Abschalten der betreffenden Infrastruktur führt.

Für den Betrieb von Ladeinfrastruktur oder von Solarwechselrichtern oder dergleichen sind FI-Schutzschalter des Typs B bekannt, welche auch Gleichstromkomponenten von Differenzströmen erfassen und überwachen können. FI-Schutzschalter des Typs B sind jedoch vergleichsweise besonders kostenintensiv.

Ein allstromsensitiver Differenzstromsensor überwacht gleichzeitig alle Ströme, die in den Phasen und dem Neutralleiter fließen und detektiert mögliche Gleich- und Wechselstromfehler. Je nach Anwendung kann der Sensor im Fehlerfall selbstständig die Abschaltung des Systems steuern oder das Überschreiten der Schaltschwelle an eine übergeordnete Steuereinheit melden. Da die tollerierbaren Fehlerströme sehr klein sind, ist eine herausragende Messgenauigkeit notwendig. Zudem erfordert die Personensicherheit ein besonders schnelles Detektieren und anschließendes Abschalten des Gesamtsystems.

Bekannte Differenzstromsensoren basieren beispielsweise auf einer Anordnung, bei der ein Magnetkern mit einem Luftspalt um einen zu überwachenden Leiter herum angeordnet ist. Im Fall eines Stromflusses wird ein Magnetfeld induziert, das durch den Magnetkern geführt wird. In dem Luftspalt ist bei bekannten Anordnungen ein Hallelement angeordnet, das in Abhängigkeit von der Magnetfeldstärke eine Ausgangsspannung erzeugt. Eine Kompensationswicklung, die an dem Magnetkern angebracht ist, kann vorgesehen sein, um die Messgenauigkeit zu erhöhen. Dies wird erreich, indem das durch den zu überwachenden Strom erzeugte Magnetfeld elektrisch kompensiert und die Nulllage des Hallsensors eingestellt wird. Das eigentliche Ausgangssignal eines derartigen Sensors stellt dabei der benötigte Strom in der Kompensationswicklung dar.

Weiterhin ist bekannt, sogenannte Flux-Gate-Sensoren für die Messung des durch den Stromfluss erzeugten Magnetfeldes einzusetzen. Bei diesem Verfahren wird eine Primärspule um den Magnetkern gewickelt und mit einem Wechselstrom angesteuert. Mittels einer sekundären Sondenspule wird ein Ausgangssignal abgegriffen, das von dem Differenzstrom abhängig ist.

Aus der EP 1 696 444 A2 ist ein Summenstromwandler zur allstromsensitiven Erfassung eines elektrischen Differenzstromes bekannt. Er umfasst eine äußere Schottung, mindestens eine Durchgangsöffnung für die überwachten Primärleiter, zwei jeweils mit einer Sekundärwicklung versehene Magnetkerne und eine magnetische Abschirmung zwischen der Schottung und den beiden Magnetkernen.

Der Erfindung liegt die Aufgabe zugrunde, dem Stand der Technik eine Verbesserung oder eine Alternative zur Verfügung zu stellen.

Nach einem ersten Aspekt der Erfindung löst die Aufgabe ein Sensor zum allstromsensitiven Bestimmen eines Differenzstroms,
- wobei der Sensor ein magnetfeldempfindliches Bauelement, eine erste Hauptwicklung, eine Testwicklung und eine Abschirmung aufweist,
- wobei das magnetfeldempfindliche Bauelement ein Bauelement aus einem weichmagnetischen Stoff ist,
- wobei das magnetfeldempfindliche Bauelement eine Durchgangsöffnung aufweist, wobei die Durchgangsöffnung des magnetfeldempfindlichen Bauelements im Querschnitt als ein Oval mit zwei Symmetrieachsen ausgebildet ist,
- wobei die erste Hauptwicklung und die Testwicklung mit jeweils einer Mehrzahl von Windungen das magnetfeldempfindliche Bauelement umschließen,
- wobei die erste Hauptwicklung dazu eingerichtet ist, aktiv mittels einer Stromquelle oder einer Spannungsquelle mit einem elektrischen Strom versorgt zu werden,
- wobei die Abschirmung einen Aufnahmeraum aufweist, welcher zum Aufnehmen des magnetfeldempfindlichen Bauelements, der ersten Hauptwicklung und der Testwicklung eingerichtet ist,
- wobei der Aufnahmeraum der Abschirmung in radialer Richtung von einer Abschirmungsaußenwand und einer Abschirmungsinnenwand begrenzt ist,
- wobei die Abschirmungsinnenwand eine Durchgangsöffnung der Abschirmung definiert, wobei die Durchgangsöffnung der Abschirmung als ein Oval mit zwei Symmetrieachsen ausgebildet ist,
- wobei die Abschirmung im Bereich der Abschirmungsinnenwand einen umlaufenden Spalt aufweist,
- wobei der Sensor dazu eingerichtet ist, um zumindest zwei elektrische Leiter herum angeordnet zu werden,
- wobei die Durchgangsöffnung des magnetfeldempfindlichen Bauelements zumindest eine lichte Weite entlang einer Symmetrieachse aufweist,
wobei die zumindest eine lichte Weite in einem Bereich zwischen 25,2 und 32 mm liegt, bevorzugt in einem Bereich zwischen 25,5 und 29 mm und besonders bevorzugt zwischen 25,8 und 27 mm. Begrifflich sei hierzu Folgendes erläutert:
Zunächst sei ausdrücklich darauf hingewiesen, dass im Rahmen der hier vorliegenden Patentanmeldung unbestimmte Artikel und Zahlenangaben wie "ein", "zwei" usw. im Regelfall als "mindestens"-Angaben zu verstehen sein sollen, also als "mindestens ein...", "mindestens zwei ..." usw., sofern sich nicht aus dem jeweiligen Kontext ausdrücklich ergibt oder es für den Fachmann offensichtlich oder technisch zwingend ist, dass dort nur "genau ein ...", "genau zwei ..." usw. gemeint sein können.

Im Rahmen der hier vorliegenden Patentanmeldung sei der Ausdruck "insbesondere" immer so zu verstehen, dass mit diesem Ausdruck ein optionales, bevorzugtes Merkmal eingeleitet wird. Der Ausdruck ist nicht als "und zwar" und nicht als "nämlich" zu verstehen.

Ein "Sensor" oder auch "Detektor" ist eine technische Baugruppe, welche bestimmte physikalische oder chemische Eigenschaften und/oder die stoffliche Beschaffenheit seiner Umgebung qualitativ oder als "Messgröße" quantitativ erfassen kann. Diese Größen werden mittels physikalischer oder chemischer Effekte erfasst und in ein analoges oder digitales elektrisches Signal umgeformt. Ein solches Signal wird auch als "Sensorsignal" bezeichnet.

Vorzugsweise ist ein Sensorsignal proportional zu einer Stromaufnahme, insbesondere der Stromaufnahme der Testwicklung und/oder der ersten Hauptwicklung und/oder einer zweiten Hauptwicklung. Vorzugsweise kann ein Sensorsignal, insbesondere ein Sensorsignal der Testwicklung und/oder der ersten Hauptwicklung und/oder einer zweiten Hauptwicklung mit einer mathematischen Vorschrift in eine Stromaufnahme überführt werden.

Unter einer "Stromaufnahme" wird die Stromstärke verstanden, welche bei einer definierten Spannung durch den Stromkreis fließt, insbesondere durch die Testwicklung und/oder die erste Hauptwicklung und/oder eine zweite Hauptwicklung. Ausdrücklich sei darauf hingewiesen, dass die Begrifflichkeit Stromaufnahme keine Aussage über das Vorzeichen des Stromes erfordert. Insbesondere kann eine Stromaufnahme einem positivem oder einem negativen Strom entsprechen.

Vorzugsweise wird unter dem Sensorsignal die Stromaufnahme der ersten Hauptwicklung verstanden. Vorzugsweise kann die Stromaufnahme der ersten Hauptwicklung mittels einer mathematischen Vorschrift in den einen Differenzstrom des von dem Sensor designiert überwachten Stromkreises überführt werden. Vorzugsweise kann diese mathematische Vorschrift durch eine Kalibrationskurve des Sensors bestimmt werden.

Unter einem "elektrischen Differenzstrom" wird die vektorielle Summe der Ströme aller elektrischen Leiter verstanden, um welche der Sensor herum angeordnet ist.

Ein elektrischer Differenzstrom kann eine Wechselstromkomponente und/oder eine Gleichstromkomponente aufweisen.

Unter einem "allstromsensitiven Bestimmen" eines Differenzstroms wird verstanden, dass der Sensor dazu eingerichtet ist, sowohl eine Wechselstromkomponente als auch eine Gleichstromkomponente bestimmen zu können.

Unter einem "magnetfeldempfindlichen Bauelement" wird ein Bauelement verstanden, welches auf ein Magnetfeld mit der Veränderung zumindest einer Zustandsgröße des Bauelements reagiert.

Vorzugsweise wird unter einem magnetfeldempfindlichen Bauelement ein Stoff verstanden, welcher magnetische Eigenschaften aufweist.

Das magnetfeldempfindliche Bauelement ist ein Bauelement aus einem weichmagnetischen Stoff.

Unter einem "weichmagnetischen Stoff" wird ein Stoff verstanden, welcher sich in einem Magnetfeld leicht magnetisieren lässt. Vorzugsweise weist ein weichmagnetischer Stoff eine Koerzitivfeldstärke von weniger gleich 1.000 A/m auf.

Unter der "Koerzitivfeldstärke" wird die magnetische Feldstärke verstanden, die notwendig ist, um ein zuvor bis zur Sättigungsflussdichte aufgeladenes magnetfeldempfindliches Bauelement vollständig zu entmagnetisieren.

Vorzugsweise wird unter einem weichmagnetischen Stoff ein Stoff verstanden, welcher aus einem amorphen Metall hergestellt worden ist und eine nanokristalline Struktur aufweist.

Insbesondere weist ein weichmagnetischer Stoff eine Legierung aufweisend Eisen, Nickel und Cobalt auf.

Unter einer "Wicklung" wird eine um ein magnetfeldempfindliches Bauelement verlaufende Aufwicklung eines elektrisch leitfähigen Materials im festen Aggregatzustand verstanden, insbesondere in Form eines Drahtes.

Unter einer "Hauptwicklung" wird eine Wicklung verstanden, die dazu eingerichtet ist, aktiv mittels einer Stromquelle mit einem elektrischen Strom versorgt zu werden. Alternativ kann eine Hauptwicklung auch mit einer Spannungsquelle verbunden sein. Eine Hauptwicklung kann auch als "erste Hauptwicklung" bezeichnet werden.

Vorzugsweise ist eine Hauptwicklung, insbesondere eine erste Hauptwicklung, dazu eingerichtet, ein Sensorsignal bereitzustellen, insbesondere mittelbar durch die Stromaufnahme der Hauptwicklung, insbesondere mittelbar durch die Stromaufnahme der ersten Hauptwicklung und/oder der zweiten Hauptwicklung.

Vorzugsweise kann aus der Stromaufnahme der Hauptwicklung, insbesondere der ersten und/oder einer zweiten Hauptwicklung, mittels einer mathematischen Vorschrift der Differenzstrom des designiert mit dem Sensor überwachten Stromkreises bestimmt werden, vorzugsweise mittels einer mathematischen Vorschrift, welche aus einer Kalibration des Sensors abgeleitet werden kann.

Unter einer "Testwicklung" wird eine Wicklung verstanden, die dazu eingerichtet ist, als rein passives Bauelement in Folge einer von dem magnetfeldempfindlichen Bauelement ausgehenden Induktionswirkung von einem elektrischen Strom durchströmt zu werden. Die Testwicklung kann vorzugsweise dazu eingerichtet sein, ein Testwicklungssignal bereitzustellen, welches im Rahmen einer Kalibration des Sensors verwendet werden kann. Insbesondere weist die Testwicklung im Vergleich zu der Hauptwicklung vorzugsweise eine andere Anzahl von Windungen auf.

Vorzugsweise wird eine Kalibration des Sensors bei jeder Aufnahme des Messbetriebs vor Beginn des eigentlichen Messbetriebs durchgeführt.

Unter einer "Abschirmung" wird ein Bauelement verstanden, welches dazu eingerichtet ist, elektrische und/oder magnetische Felder von dem magnetfeldempfindlichen Bauelement fernzuhalten und/oder die Umgebung des Sensors von den von dem Sensor ausgehenden elektrischen und/oder magnetischen Feldern zu schützen.

Vorzugsweise besteht die Abschirmung aus einer Legierung, welche größer gleich 20 Gew.-% Nickel aufweist, bevorzugt größer gleich 30 Gew.-% Nickel und besonderes bevorzugt größer gleich 50 Gew.- % Nickel. Weiterhin bevorzugt besteht die Abschirmung aus einer Legierung, welche größer gleich 60 Gew.-% Nickel aufweist, weiterhin bevorzugt größer gleich 70 Gew.-% Nickel und besonderes bevorzugt größer gleich 80 Gew.-% Nickel.

Vorzugsweise besteht die Abschirmung aus einer Legierung, welche größer gleich 0,5 Gew.-% Molybdän aufweist, bevorzugt größer gleich 1 Gew.-% Molybdän und besonderes bevorzugt größer gleich 3 Gew.-% Molybdän. Weiterhin bevorzugt besteht die Abschirmung aus einer Legierung, welche größer gleich 4 Gew.-% Molybdän aufweist, weiterhin bevorzugt größer gleich 5 Gew.-% Molybdän und besonderes bevorzugt größer gleich 5,5 Gew.-% Molybdän.

Vorzugsweise besteht die Abschirmung aus einer Legierung, welche größer gleich 10 Gew.-% Eisen aufweist, bevorzugt größer gleich 20 Gew.-% Eisen und besonderes bevorzugt größer gleich 30 Gew.- % Eisen. Weiterhin bevorzugt besteht die Abschirmung aus einer Legierung, welche größer gleich 40 Gew.-% Eisen aufweist, weiterhin bevorzugt größer gleich 50 Gew.-% Eisen und besonderes bevorzugt größer gleich 55 Gew.-% Eisen.

Ausdrücklich sei darauf hingewiesen, dass die vorstehenden Werte für die Legierungszusammensetzung der Abschirmung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Legierungszusammensetzung der Abschirmung liefern.

Vorzugsweise ist die Abschirmung mehrteilig ausgebildet, insbesondere zweiteilig ausgebildet.

Besonders bevorzugt ist eine zweiteilige Abschirmung derart ausgebildet, dass sich die beiden Abschirmungsteile an der Abschirmungsaußenwand überlappen oder zumindest teilweise überlappen.

Weiterhin besonders bevorzugt ist eine zweiteilige Abschirmung derart ausgebildet, dass sich die beiden Abschirmungsteile an der Abschirmungsinnenwand nicht berühren, wobei die beiden Abschirmungsteile einer zweiteiligen Abschirmung weiterhin bevorzugt einen Spalt an der Abschirmungsinnenwand ausbilden.

Unter einer "Durchgangsöffnung" wird ein freier Querschnitt verstanden, der im Innenbereich des magnetfeldempfindlichen Bauelements ausgebildet ist.

Besonders bevorzugt ist die äußere Kontur des magnetfeldempfindlichen Bauelements als ein Oval ausgebildet und die innere Kontur des magnetfeldempfindlichen Bauelements ebenfalls als Oval mit zwei Symmetrieachsen ausgebildet.

Die innere Kontur des magnetfeldempfindlichen Bauelements formt die Durchgangsöffnung des magnetfeldempfindlichen Bauelements aus.

Vorzugsweise ist die Materialstärke des magnetfeldempfindlichen Bauelements weitestgehend konstant oder konstant. In dem Sonderfall in welchem das magnetfeldempfindliche Bauelement im Querschnitt als ein Kreis ausgebildet ist und die Materialstärke des magnetfeldempfindlichen Bauelements konstant ist, weist das magnetfeldempfindliche Bauelement im Querschnitt die Geometrie eines Kreisrings auf.

Ein "Oval" ist eine ebene rundliche konvexe Figur. Ein Oval umfasst Kreise und Ellipsen als Spezialfälle, wobei ein beliebiges Oval im Gegensatz zu diesen keine "Symmetrieachse" besitzen muss. Insbesondere ist ein Oval eine geschlossene zweimal stetig differenzierbare konvexe Kurve in der Ebene.

Ist die Kurve eines Ovals spiegelbildlich zu beiden Seiten einer gedachten Linie angeordnet, so weist das Oval eine Symmetrieachse auf. Ist die Kurve eines Ovals spiegelbildlich zu beiden Seiten zweier nicht zusammenfallender gedachten Linie angeordnet, so weist das Oval "zwei Symmetrieachsen" auf. Insbesondere sind ein Kreis und eine Ellipse jeweils ein Oval mit zwei Symmetrieachsen.

Unter einer "Windung" wird ein Umlauf einer Wicklung um das magnetfeldempfindliche Bauelement verstanden.

Unter einem "Aufnahmeraum" wird der Raum verstanden, welcher im Inneren der Abschirmung von der Abschirmung ausgeformt wird und welcher dazu eingerichtet ist, weitere Bauelemente aufzunehmen, insbesondere das magnetfeldempfindliche Bauelement, die erste Hauptwicklung und die Testwicklung sowie vorzugsweise auch eine zweite Hauptwicklung, einen Isolator und einen Distanzring.

Unter einer "radialen Richtung" wird eine Richtung verstanden, die von einer zentralen Achse des Sensors aus, welche normal zur kleinstmöglichen Querschnittsfläche der Durchgangsöffnung verläuft, geradlinig in radialer Richtung zu der zentralen Achse verläuft.

Unter einer "Abschirmungsaußenwand" wird die in radialer Richtung betrachtet äußere Fläche verstanden, welche von der Abschirmung, insbesondere von einer zusammengesteckten zweiteiligen Abschirmung, gebildet wird.

Unter einer "Abschirmungsinnenwand" wird die in radialer Richtung betrachtet innere Fläche verstanden, welche von der Abschirmung gebildet wird, insbesondere von der projizierten Fläche, welche etwaige Teilflächen der innenliegenden Abschirmung und des umlaufenden Spalts aufweist, gebildet wird.

Unter einem "umlaufenden Spalt" wird ein in der Abschirmungsinnenwand umlaufender Spalt zwischen den Teilflächen der von der Abschirmung gebildeten Abschirmungsinnenwand verstanden. In radialer Richtung und ausgehend von der zentralen Achse betrachtet öffnet der umlaufende Spalt die Abschirmung in Richtung des Aufnahmeraums der Abschirmung.

Unter einem "elektrischen Leiter" wird jedes Medium verstanden, welches bewegliche Ladungsträger besitzt und somit zum Transport elektrischer Ladung fähig ist. Vorzugsweise wird unter einem elektrischen Leiter ein Kupfer-Kabel und/oder ein Aluminium-Kabel als Leiter verstanden durch welches sich Elektronen bewegen können.

Unter einer "lichten Weite" entlang einer Symmetrieachse der Durchgangsöffnung wird die Erstreckung der Durchgangsöffnung in Richtung und auf der Höhe der betrachteten Symmetrieachse verstanden.

Weist das die Durchgangsöffnung des magnetfeldempfindlichen Bauelements im Querschnitt bildende Oval zwei Symmetrieachsen mit unterschiedlichen Erstreckungen entlang der Symmetrieachsen auf, so ergibt sich eine erste lichte Weite entlang der ersten Symmetrieachse und eine zweite lichte Weite entlang der zweiten Symmetrieachse.

Soweit in der vorliegenden Beschreibung lediglich von einer lichten Weite gesprochen wird, so ist hiermit vorzugsweise die lichte Weite entlang der Symmetrieachse mit der größeren Erstreckung gemeint.

Unter einem "Grenzstrom" wird ein Differenzstrom verstanden, den ein Sensor in ausreichender Genauigkeit und mit hinreichender Geschwindigkeit erfassen kann, sodass ein Schutzschalter die Spannung in dem von dem Sensor überwachten Stromkreis unterbrechen kann, sobald ein Differenzstrom von dem Sensor erfasst wird, der den Grenzstrom des Schutzschalters mindestens erreicht oder überschreitet.

Je kleiner der Grenzstrom eines Schutzschalters und damit unmittelbar auch die Messeignung geringer Differenzströme des Sensors ist und je schneller dieser sicher von dem Sensor erkannt wird, desto geringer ist die Gefahr, welche von einem auftretenden Differenzstrom ausgehen kann.

Im Stand der Technik sind Sensoren mit einer kleineren lichten Weite der Durchgangsöffnung des magnetfeldempfindlichen Bauelements als hier vorgeschlagen bekannt.

Insbesondere ist die herkömmliche Bestrebung, die lichte Weite der Durchgangsöffnung des magnetfeldempfindlichen Bauelements zu reduzieren.

Diese Bestrebung ist dadurch motiviert, dass die Forderung nach kleineren und schneller erfassbaren Differenzströmen erfordert, dass das magnetfeldempfindliche Bauelement möglichst dicht an den stromführenden elektrischen Leitern des überwachten Stromkreises angeordnet sein soll.

Die magnetische Feldstärke, die von einem stromführenden elektrischen Leiter ausgeht, fällt antiproportional zum Abstand zu dem stromführenden elektrischen Leiter. Je weiter demnach das magnetfeldempfindliche Bauelement von den stromführenden elektrischen Leitern des überwachten Stromkreises entfernt ist, desto geringer ist die in dem magnetfeldempfindlichen Bauelement von der magnetischen Feldstärke um die stromführenden elektrischen Leiter hervorgerufene magnetische Flussdichte in dem magnetfeldempfindlichen Bauelement.

Verstärkend hierzu kommt hinzu, dass sich die magnetische Feldstärke der zumindest zwei stromführenden elektrischen Leiter des überwachten Stromkreises, welche beide zur Überwachung eines Differenzstroms durch die Durchgangsöffnung des magnetfeldempfindlichen Bauelements geführt werden müssen, und welche gegenläufige Stromflussrichtungen aufweisen, überlagern und sich in der idealisierten Betrachtung gegenseitig aufheben, sofern kein Differenzstrom in dem überwachten Stromkreis auftritt.

Hierdurch ist die auf das magnetfeldempfindliche Bauelement einwirkende magnetische Feldstärke insbesondere bei kleinen Differenzströmen in dem überwachten Stromkreis besonders gering, wodurch eine besonders geringe magnetische Flussdichte in dem magnetfeldempfindlichen Bauelement hervorgerufen wird.

Je geringer die magnetische Flussdichte in dem magnetfeldempfindlichen Bauelement ist, desto geringer ist auch der elektrische Strom, den die magnetische Flussdichte in dem magnetfeldempfindlichen Bauelement in der Testwicklung und/oder der ersten Hauptwicklung und/oder einer zweiten Hauptwicklung hervorruft.

Mit anderen Worten, je größer die lichte Weite der Durchgangsöffnung des magnetfeldempfindlichen Bauelements, desto größer kann auch der Abstand der elektrischen Leiter des überwachten Stromkreises zu dem magnetfeldempfindlichen Bauelement sein, wodurch ein kleiner Differenzstrom überhaupt nicht oder nur besonders schwierig erfasst werden kann.

Aus diesem Grund führt die Forderung nach kleineren erfassbaren Differenzströmen zu der technischen Bestrebung, dass die lichte Weite der Durchgangsöffnung des magnetfeldempfindlichen Bauelements so klein wie möglich ist.

Ein möglichst kleines magnetfeldempfindliches Bauelement führt weiterhin zu einem geringen Gewicht des Sensors, einem geringen Materialbedarf und damit geringeren Kosten sowie einer geringeren Bauraumanforderung.

Somit sprechen viele Faktoren für eine kleinere lichte Weite der Durchgangsöffnung des magnetfeldempfindlichen Bauelements.

Im Stand der Technik ist bekannt, dass Schutzschalter mit einem sehr geringen Differenzstrom dazu neigen, beim Einschalten des überwachten Stromkreises fehlerhaft auszulösen.

Ursache hierfür ist, dass im Stand der Technik bekannte Sensoren beim Einschalten des Stromkreises ein Sensorsignal erzeugen, welches als Differenzstrom interpretiert werden kann, obgleich kein Differenzstrom in dem überwachten Stromkreis vorliegen muss. Die Forderung nach kleineren Differenzströmen führt dazu, dass die Anzahl an fehlerhaften Auslösungen von Schutzschaltern zugenommen hat.

Bei Laborversuchen wurde nun entgegen der herkömmlichen Auffassung vollkommen unerwartet herausgefunden, dass es einen optimalen Bereich einer lichten Weite der Durchgangsöffnung des magnetfeldempfindlichen Bauelements gibt, in welchem kleinstmögliche Differenzströme in hinreichender Zeit erfasst werden können und gleichzeitig die Wahrscheinlichkeit eines fehlerhaften Auslösens eines mit dem Sensor verbundenen Schutzschalters signifikant reduziert werden kann, wobei der entdeckte Bereich eine größere lichte Weite der Durchgangsöffnung des magnetfeldempfindlichen Bauelements fordert, als dies im Stand der Technik bislang bekannt war.

Mit anderen Worten wurde ein Bereich einer lichten Weite der Durchgangsöffnung herausgefunden, welcher es ermöglicht einen kleinstmöglichen Differenzstrom robust zu bestimmen, sodass keine oder nur signifikant seltener auftretende Sensorsignale beim Einschalten des mit dem Sensor überwachten Stromkreises auftreten, die als ein Differenzstrom interpretierbar sind, die über dem geforderten Grenzstrom liegen.

Um einen robust mit dem Sensor bestimmbaren minimalen Grenzstrom in dem überwachten Stromkreis zu erreichen, wird vorgeschlagen, dass die lichte Weite der Durchgangsöffnung des magnetfeldempfindlichen Bauelements in einem Bereich zwischen 25,2 und 32 mm liegt.

Bevorzugt wird vorgeschlagen, dass die lichte Weite der Durchgangsöffnung des magnetfeldempfindlichen Bauelements in einem Bereich zwischen 25,5 und 29 mm liegt.

Besonders bevorzugt wird vorgeschlagen, dass die lichte Weite der Durchgangsöffnung des magnetfeldempfindlichen Bauelements in einem Bereich zwischen 25,8 und 27 mm liegt.

Ausdrücklich sei darauf hingewiesen, dass die vorstehenden Werte für die lichte Weite der Durchgangsöffnung des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen lichten Weite der Durchgangsöffnung des magnetfeldempfindlichen Bauelements liefern.

Es versteht sich, dass die angegebenen Bereichsgrenzen für die lichte Weite auch beliebig miteinander kombiniert werden können.

Beim Einschalten der Spannungsversorgung an einem zu überwachenden Stromkreis baut sich eine physikalische Wirkverbindung zwischen dem sich um einen elektrischen Leiter ausbreitenden magnetischen Feld und der hiermit in einem Wirkzusammenhang stehenden magnetischen Flussdichte auf.

Dies führt beim Einschalten zu einem kurzfristigen zeitvarianten pulsieren des kurzzeitig auch ortsabhängigen magnetischen Flusses in dem magnetfeldempfindlichen Bauelement.

Dies führt kurzzeitig zu einem Schwingungsverhalten des magnetischen Flusses in dem magnetfeldempfindlichen Bauelement.

Durch dieses kurzzeitige Schwingungsverhalten in dem magnetfeldempfindlichen Bauelement kommt es kurzfristig auch zu einem pulsierenden Stromfluss in der Testwicklung und/oder der ersten Hauptwicklung und/oder einer zweiten Hauptwicklung, die mittels Induktion ebenfalls in einem Wirkzusammenhang mit dem magnetfeldempfindlichen Bauelement steht.

Laboruntersuchungen haben gezeigt, dass es hierdurch kurzfristig zu einem Sensorsignal kommen kann, welches als Differenzstrom interpretiert werden kann, wodurch im designierten Betrieb des Sensors in einem Schutzschalter ein vordefinierter Grenzstrom überschritten werden kann. Hierdurch kann es zu einem Abschalten des Schutzschalters beim Einschalten der Spannungsversorgung für den zu überwachenden Stromkreis kommen.

Dämpfend auf dieses kurzzeitige Schwingungsverhalten wirken eine Mehrzahl unterschiedlicher Faktoren. Einige dieser Faktoren sind nicht durch gestalterische Maßnahmen beeinflussbar.

Es wurde bei Laboruntersuchungen herausgefunden, dass einer dieser Faktoren durch die Abstände der elektrischen Leiter zueinander, welche durch den hier vorgeschlagenen Sensor überwacht werden sollen, bestimmt wird. Je größer der vorbeschriebene Abstand oder die vorbeschriebenen Abstände sind, desto stärker ist der dynamische Wirkzusammenhang zwischen den elektrischen Leitern und dem Sensorsignal beim Einschalten der Spannungsversorgung.

Für die Abstände der elektrischen Leiter im Querschnitt der Durchgangsöffnung des magnetfeldempfindlichen Bauelements werden wegen bestehender Sicherheitsbedenken stetig höhere Abstände gefordert, um Kurzschlüsse zwischen den elektrischen Leitern zu vermeiden. Hierdurch wird dieser Faktor angefacht und die Neigung eines ungewollten Sensorsignals beim Einschalten des Stromkreises erhöht.

Ein anderer ebenfalls bei Laboruntersuchungen identifizierter Faktor hat mit dem Verhältnis der Abstände eines ersten elektrischen Leiters und eines abweichenden elektrischen Leiters zu einem Punkt in dem magnetfeldempfindlichen Bauelement zu tun. Je weiter das beschriebene Verhältnis von der Zahl eins abweicht, desto größer sind die sich kurzfristig einstellenden regionalen Unterschiede der magnetischen Flussdichte in dem magnetfeldempfindlichen Bauelement. Je größer diese regionalen Unterschiede sind, desto stärker wird das dynamische Startverhalten des Sensors beim Einschalten des Stromkreises angefacht.

Durch eine Ausweitung der lichten Weite der Durchgangsöffnung des magnetempfindlichen Bauelements kann das Verhältnis der Abstände eines ersten elektrischen Leiters und eines abweichenden elektrischen Leiters zu einem Punkt in dem magnetfeldempfindlichen Bauelement näher an den Zahlenwert eins herangeführt werden, wodurch eine dämpfende Wirkung des Sensorverhaltens durch den oberhalb beschriebenen Einschalteffekt vorteilhaft erreicht werden kann.

Da eine Ausweitung der lichten Weite des magnetfeldempfindlichen Bauelements auch zu einer geringeren Sensitivität für besonders kleine Differenzströme führt, wird hier ein optimaler Bereich für die lichte Weite der Durchgangsöffnung des magnetfeldempfindlichen Bauelements vorgeschlagen, welcher beide physikalischen Effekte derart berücksichtigt, dass einerseits ein minimaler Differenzstrom im Regelbetrieb des Sensors in hinreichender Zeit erkannt werden kann und andererseits beim Einschalten des von dem Sensor überwachten Stromnetz kein Sensorsignal auftritt, welches die fehlerhafte Detektion eines nicht vorhandenen Differenzstroms vermittelt.

Konkret wird hier ebenfalls vorgeschlagen, den Sensor derart zu gestalten, dass er um alle Leiter eines Stromkreises angeordnet werden kann, die im regulären Betrieb einen elektrischen Stromfluss in den zu überwachenden Stromkreis einleiten und einen elektrischen Stromfluss in den zu überwachenden Stromkreis ausleiten. Insbesondere wird vorgeschlagen, dass der hier vorgeschlagene Sensor nicht um den Schutzleiter herum angeordnet werden soll.

Insbesondere wird vorgeschlagen, den hier vorgeschlagenen Sensor im designierten Einsatz bei einem einphasigen Stromnetz um den Außenleiter und den Neutralleiter herum anzuordnen. Demnach soll der Sensor in einem einphasigen Stromnetz um zwei elektrische Leiter herum angeordnet werden.

Weiterhin wird bei designiertem Einsatz in einem dreiphasigen Stromnetz vorgeschlagen, den Sensor um die drei Außenleiter und den Neutralleiter anzuordnen. Somit soll der Sensor in einem dreiphasigen Stromnetz um insgesamt vier elektrische Leiter herum angeordnet werden.

Vorzugsweise wird vorgeschlagen, dass die Durchgangsöffnung des magnetfeldempfindlichen Bauelements im Querschnitt einen Kreis aufweist, also ein Oval mit zwei gleich langen Halbradien.

Weiterhin vorzugsweise wird vorgeschlagen, dass die Durchgangsöffnung des magnetfeldempfindlichen Bauelements im Querschnitt eine Ellipse aufweist, also ein Oval mit zwei unterschiedlich langen Halbradien.

Ausdrücklich wird darauf hingewiesen, dass das Merkmal, dass die Durchgangsöffnung des magnetfeldempfindlichen Bauelements im Querschnitt als ein Oval mit zwei Symmetrieachsen ausgebildet ist, nicht wesentlich im Sinne der vorliegenden Erfindung ist.

Vielmehr sind hier konkret auch andere Geometrien des magnetfeldempfindlichen Bauelements denkbar, welche einen guten Kompromiss hinsichtlich der vorbeschriebenen physikalischen Effekte erlauben. Vorzugsweise gehen auch diese Geometrien auf einen ovalförmigen Querschnitt zurück.

Entsprechend der Geometrie des magnetfeldempfindlichen Bauelements wird vorgeschlagen auch die Geometrie der Abschirmung entsprechend anzupassen.

Konkret wird hier ebenfalls vorgeschlagen, dass das magnetfeldempfindliche Bauelement eine hohe Permeabilität aufweist.

Unter einer "Permeabilität" eines magnetfeldempfindlichen Bauelements wird die Magnetisierung eines Materials in einem äußeren Magnetfeld verstanden. Je höher die Permeabilität eines magnetfeldempfindlichen Bauelements ist, desto größer ist das Verhältnis aus magnetischer Flussdichte in dem magnetfeldempfindlichen Bauelement und magnetischer Feldstärke, welche auf das magnetfeldempfindliche Bauelement einwirkt.

So führt ein magnetfeldempfindliches Bauelement mit einer hohen Permeabilität dazu, dass auch bei einer geringen magnetischen Feldstärke eine vergleichsweise hohe magnetische Flussdichte in dem magnetfeldempfindlichen Bauelement vorliegt. Somit erhöht eine hohe Permeabilität des magnetfeldempfindlichen Bauelements die Sensitivität des Sensors und unterstützt dabei, dass bereits geringe Differenzströme von dem Sensor detektiert werden können.

Vorzugsweise wird vorgeschlagen, dass das magnetfeldempfindliche Bauelement eine Permeabilität aufweist, die größer gleich ist als 35.000 H/m (Henry pro Meter), bevorzugt weist das magnetfeldempfindliche Bauelement eine Permeabilität von größer gleich 45.000 H/m auf, besonders bevorzugt weist das magnetfeldempfindliche Bauelement eine Permeabilität von größer gleich 50.000 H/m auf. Weiterhin bevorzugt weist das magnetfeldempfindliche Bauelement eine Permeabilität von größer gleich 60.000 H/m auf, bevorzugt weist das magnetfeldempfindliche Bauelement eine Permeabilität von größer gleich 70.000 H/m auf, besonders bevorzugt weist das magnetfeldempfindliche Bauelement eine Permeabilität von größer gleich 80.000 H/m auf. Ebenfalls weiterhin bevorzugt weist das magnetfeldempfindliche Bauelement eine Permeabilität von größer gleich 90.000 H/m auf, bevorzugt weist das magnetfeldempfindliche Bauelement eine Permeabilität von größer gleich 100.000 H/m auf, besonders bevorzugt weist das magnetfeldempfindliche Bauelement eine Permeabilität von größer gleich 110.000 H/m auf. Weiterhin bevorzugt weist das magnetfeldempfindliche Bauelement eine Permeabilität von größer gleich 120.000 H/m auf, bevorzugt weist das magnetfeldempfindliche Bauelement eine Permeabilität von größer gleich 130.000 H/m auf, besonders bevorzugt weist das magnetfeldempfindliche Bauelement eine Permeabilität von größer gleich 140.000 H/m auf. Vorzugsweise ist die Permeabilität des magnetfeldempfindlichen Bauelements größer gleich 150.000 H/m.

Die oberhalb benannten Werte für die Permeabilität gelten bei einem mit 50 Hz oszillierenden Magnetfeld.

Ausdrücklich sei darauf hingewiesen, dass die vorstehenden Werte für die Permeabilität des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Permeabilität des magnetfeldempfindlichen Bauelements liefern.

Vorzugsweise weist das magnetfeldempfindliche Bauelement eine magnetische Sättigungsflussdichte auf, die größer gleich ist als 1 T, bevorzugt weist das magnetfeldempfindliche Bauelement eine magnetische Sättigungsflussdichte von größer gleich 1,1 T auf, besonders bevorzugt weist das magnetfeldempfindliche Bauelement eine magnetische Sättigungsflussdichte von größer gleich 1,2 T auf. Vorzugsweise weist das magnetfeldempfindliche Bauelement eine magnetische Sättigungsflussdichte von größer gleich 1,3 T auf.

Ausdrücklich sei darauf hingewiesen, dass die vorstehenden Werte für die magnetische Sättigungsflussdichte des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen magnetischen Sättigungsflussdichte des magnetfeldempfindlichen Bauelements liefern.

Vorzugsweise wird hier vorgeschlagen, dass das magnetfeldempfindliche Bauelement ein hohes Maß an Linearität hinsichtlich der Permeabilität aufweist, insbesondere eine höhere Linearität hinsichtlich der Permeabilität als ein ferritischer Werkstoff. Mit anderen Worten wird vorzugsweise vorgeschlagen keinen ferritischen Werkstoff für das magnetfeldempfindliche Bauelement einzusetzen.

Je höher die Linearität hinsichtlich der Permeabilität des magnetfeldempfindlichen Bauelements ist, desto höher ist die erreichbare Meßgenauigkeit des Sensors.

Vorzugsweise weist das magnetfeldempfindliche Bauelement eine Koerzitivfeldstärke auf, die kleiner gleich ist als 30 mA/cm, bevorzugt weist das magnetfeldempfindliche Bauelement eine Koerzitivfeldstärke von kleiner gleich 20 mA/cm auf, besonders bevorzugt weist das magnetfeldempfindliche Bauelement eine Koerzitivfeldstärke von kleiner gleich 15 mA/cm auf. Weiterhin bevorzugt weist das magnetfeldempfindliche Bauelement eine Koerzitivfeldstärke von kleiner gleich 10 mA/cm auf, bevorzugt weist das magnetfeldempfindliche Bauelement eine Koerzitivfeldstärke von kleiner gleich 5 mA/cm auf, besonders bevorzugt weist das magnetfeldempfindliche Bauelement eine Koerzitivfeldstärke von kleiner gleich 2 mA/cm auf. Weiterhin bevorzugt weist das magnetfeldempfindliche Bauelement eine Koerzitivfeldstärke von kleiner gleich 1 mA/cm auf, bevorzugt weist das magnetfeldempfindliche Bauelement eine Koerzitivfeldstärke von kleiner gleich 0,5 mA/cm auf, besonders bevorzugt weist das magnetfeldempfindliche Bauelement eine Koerzitivfeldstärke von kleiner gleich 0,2 mA/cm auf. Vorzugsweise weist das magnetfeldempfindliche Bauelement eine Koerzitivfeldstärke von kleiner gleich 0,1 mA/cm auf.

Die oberhalb genannten Werte für die Koerzitivfeldstärke gelten bei einem mit 50 Hz oszillierenden Magnetfeld.

Durch eine geringe Koerzitivfeldstärke des magnetfeldempfindlichen Bauelements kann, insbesondere bei wechselnden Feldstärken des magnetischen Feldes, eine besonders hohe Messgenauigkeit erreicht werden. Je niedriger die Koerzitivfeldstärke des magnetempfindlichen Bauelements, desto höher die Messgenauigkeit des Sensors.

Ausdrücklich sei darauf hingewiesen, dass die vorstehenden Werte für die Koerzitivfeldstärke des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Koerzitivfeldstärke des magnetfeldempfindlichen Bauelements liefern.

Es wird vorgeschlagen das magnetfeldempfindliche Bauelement aus einem weichmagnetischen Stoff auszuwählen oder herzustellen.

Vorzugsweise besteht das magnetfeldempfindliche Bauelement aus einer Legierung, welche größer gleich 70 Gew.-% Eisen aufweist, bevorzugt größer gleich 71,5 Gew.-% Eisen und besonderes bevorzugt größer gleich 73 Gew.-% Eisen. Vorzugsweise besteht das magnetfeldempfindliche Bauelement aus einer Legierung, welche größer gleich 73,5 Gew.-% Eisen aufweist.

Vorzugsweise besteht das magnetfeldempfindliche Bauelement aus einer Legierung, welche Kuper in einem Bereich von 0,75 bis 1,25 Gew.-% aufweist, bevorzugt Kupfer in einem Bereich von 0,85 bis 1,15 Gew.-%, besonders bevorzugt Kupfer in einem Bereich von 0,95 bis 1,05 Gew.-%. Vorzugsweise weist die Legierung des magnetfeldempfindlichen Bauelements Kupfer in einem Anteil von 1 Gew.-% auf.

Vorzugsweise besteht das magnetfeldempfindliche Bauelement aus einer Legierung, welche Niob in einem Bereich von 2 bis 4 Gew.- % aufweist, bevorzugt Niob in einem Bereich von 2,5 bis 3,5 Gew.- %, besonders bevorzugt Niob in einem Bereich von 2,8 bis 3,2 Gew.-%. Vorzugsweise weist die Legierung des magnetfeldempfindlichen Bauelements Niob in einem Anteil von 3 Gew.-% auf.

Vorzugsweise besteht das magnetfeldempfindliche Bauelement aus einer Legierung, welche Bor in einem Bereich von 5 bis 9 Gew.-% aufweist, bevorzugt Bor in einem Bereich von 6 bis 8 Gew.-%, besonders bevorzugt Bor in einem Bereich von 6,5 bis 7,5 Gew.- %. Vorzugsweise weist die Legierung des magnetfeldempfindlichen Bauelements Bor in einem Anteil von 7 Gew.-% auf.

Vorzugsweise besteht das magnetfeldempfindliche Bauelement aus einer Legierung, welche Silicium in einem Bereich von 14 bis 17 Gew.-% aufweist, bevorzugt Silicium in einem Bereich von 15 bis 16 Gew.-%, besonders bevorzugt Silicium in einem Bereich von 15,4 bis 15,6 Gew.-%. Vorzugsweise weist die Legierung des magnetfeldempfindlichen Bauelements Silicium in einem Anteil von 15,5 Gew.-% auf.

Ausdrücklich sei darauf hingewiesen, dass die vorstehenden Werte für die Legierungszusammensetzung des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Legierungszusammensetzung des magnetfeldempfindlichen Bauelements liefern.

Vorzugsweise besteht das magnetfeldempfindliche Bauelement aus einem nanokristallinen weichmagnetischen Stoff mit einer typischen Korngröße im Bereich von 5 bis 30 µm, bevorzugt aus einem nanokristallinen weichmagnetischen Stoff mit einer typischen Korngröße im Bereich von 7 bis 20 µm, besonders bevorzugt aus einem nanokristallinen weichmagnetischen Stoff mit einer typischen Korngröße im Bereich von 8 bis 15 µm.

Vorzugsweise ist das magnetfeldempfindliche Bauelement aus einem Band mit einer besonders geringen Banddicke hergestellt, da auf diese Weise gemäß den Maxwell-Gleichungen die Wirbelstromverluste in dem magnetfeldempfindlichen Bauelement niedrig gehalten werden können.

Vorzugsweise weist das magnetfeldempfindliche Bauelement eine Banddicke in einem Bereich zwischen 5 und 50 µm auf. Vorzugsweise liegt die Banddicke des magnetfeldempfindlichen Bauelements in einem Bereich zwischen 7,5 und 40 µm und besonderes bevorzugt in einem Bereich zwischen 10 und 30 µm.

Ausdrücklich sei darauf hingewiesen, dass die vorstehenden Werte für die Banddicke des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Banddicke des magnetfeldempfindlichen Bauelements liefern.

Vorzugsweise liegt der Eisenquerschnitt des magnetfeldempfindlichen Bauelements in einem Bereich zwischen 0,03 und 0,15 cm². Weiterhin vorzugsweise liegt der Eisenquerschnitt des magnetfeldempfindlichen Bauelements in einem Bereich zwischen 0,04 und 0,12 cm². Besonders bevorzugt liegt der Eisenquerschnitt des magnetfeldempfindlichen Bauelements in einem Bereich zwischen 0,05 und 0,1 cm².

Vorzugsweise weist das magnetfeldempfindliche Bauelement eine Höhe zwischen 3 und 7 mm auf, bevorzugt weist das magnetfeldempfindliche Bauelement eine Höhe zwischen 3,4 und 6,6 mm auf, besonders bevorzugt weist das magnetfeldempfindliche Bauelement eine Höhe zwischen 3,8 und 6,2 mm auf.

Ausdrücklich sei darauf hingewiesen, dass die vorstehenden Werte für den Eisenquerschnitt und die Höhe des magnetfeldempfindlichen Bauelements nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe des hier vorgeschlagenen Eisenquerschnitts und der Höhe des magnetfeldempfindlichen Bauelements liefern.

Vorzugsweise wird vorgeschlagen, dass der Sensor den Differenzstrom nach dem Wirkprinzip einer Förster-Sonde bestimmt.

Vorzugsweise sind die Anzahl der Wicklungen der ersten Hauptwicklung äquidistant über den gesamten Umlauf des magnetfeldempfindlichen Bauelements verteilt.

Vorzugsweise weist die erste Hauptwicklung eine Windungsanzahl in einem Bereich zwischen 25 und 150 Wicklungen auf, bevorzugt eine Windungsanzahl in einem Bereich zwischen 35 und 135 Wicklungen, besonders bevorzugt eine Windungsanzahl in einem Bereich zwischen 40 und 130 Wicklungen. Weiterhin vorzugsweise weist die erste Hauptwicklung eine Windungsanzahl in einem Bereich zwischen 45 und 125 Wicklungen auf, bevorzugt eine Windungsanzahl in einem Bereich zwischen 50 und 120 Wicklungen, besonders bevorzugt eine Windungsanzahl in einem Bereich von 60 bis 110 Wicklungen.

Vorteilhaft kann mit der hier vorgeschlagenen Anzahl von Windungen der ersten Hauptwicklung erreicht werden, dass das magnetfeldempfindliche Bauelement mit möglichst äquidistantem Abstand zwischen den einzelnen Wicklungen umwickelt werden kann, damit sich beim Bestromen der ersten Hauptwicklung eine möglichst lokal homogene magnetische Flussdichte in dem magnetfeldempfindlichen Bauelement einstellt.

Ausdrücklich sei darauf hingewiesen, dass die vorstehenden Werte für die Windungsanzahl der ersten Hauptwicklung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Windungsanzahl der ersten Hauptwicklung liefern.

Vorzugsweise sind die Anzahl der Wicklungen der Testwicklungen äquidistant über den gesamten Umlauf des magnetfeldempfindlichen Bauelements verteilt.

Vorzugsweise weist die Testwicklung eine Windungsanzahl in einem Bereich zwischen 3 und 40 Wicklungen auf, bevorzugt eine Windungsanzahl in einem Bereich zwischen 4 und 35 Wicklungen, besonders bevorzugt eine Windungsanzahl in einem Bereich zwischen 5 und 30 Wicklungen. Weiterhin vorzugsweise weist die Testwicklung eine Windungsanzahl in einem Bereich zwischen 6 und 25 Wicklungen auf, bevorzugt eine Windungsanzahl in einem Bereich zwischen 8 und 22 Wicklungen, besonders bevorzugt eine Windungsanzahl in einem Bereich von 10 bis 18 Wicklungen.

Vorteilhaft kann mit der hier vorgeschlagenen Anzahl von Windungen der Testwicklung erreicht werden, dass die magnetische Flussdichte in dem magnetfeldempfindlichen Bauelement über die Induktionswirkung, welche sie in der Testwicklung hervorruft, besonders genau bestimmt werden kann, insbesondere weil die Testwicklung mit äquidistanten Abständen zwischen benachbarten Windungen homogen über das magnetfeldempfindliche Bauelement verteilt werden kann.

Ausdrücklich sei darauf hingewiesen, dass die vorstehenden Werte für die Windungsanzahl der Testwicklung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Windungsanzahl der Testwicklung liefern.

Der hier vorgeschlagene Bereich der Durchgangsöffnung des magnetfeldempfindlichen Bauelements führt bei einer idealen funktionalen Gestaltung der Abschirmung zu einem lichten Maß der Durchgangsöffnung der Abschirmung in einem Bereich zwischen 18,2 bis 30 mm, bevorzugt zu einem lichten Maß der Durchgangsöffnung der Abschirmung in einem Bereich zwischen 19,5 bis 27,5 mm und besonders bevorzugt zu einem lichten Maß der Durchgangsöffnung der Abschirmung in einem Bereich zwischen 20,5 bis 24,2 mm. Besonders bevorzugt liegt das lichte Maß der Durchgangsöffnung der Abschirmung in einem Bereich zwischen 20,8 bis 22,2 mm.

Ausdrücklich sei darauf hingewiesen, dass die vorstehenden Werte für den Bereich des lichten Maßes der Durchgangsöffnung der Abschirmung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe des hier vorgeschlagenen Bereichs des lichten Maßes der Durchgangsöffnung der Abschirmung liefern.

Es versteht sich, dass die angegebenen Bereichsgrenzen für das lichte Maß auch beliebig miteinander kombiniert werden können. Gemäß einer bevorzugten Ausführungsform ist das magnetempfindliche Bauelement von einem Isolator ummantelt, wobei der Isolator zwischen dem magnetfeldempfindlichen Bauelement und der ersten Hauptwicklung und zwischen dem magnetfeldempfindlichen Bauelement und der Testwicklung angeordnet ist.

Begrifflich sei hierzu Folgendes erläutert:
Unter einem "Isolator" wird ein Bauelement aus einem Stoff verstanden, dessen elektrische Leitfähigkeit besonders klein ist, sodass er im Vergleich zu den ihn umgebenden Stoffen nur äußerst geringfügig für einen elektrischen Strom leitend ist.

Vorzugsweise ist ein Isolator zweiteilig ausgebildet, sodass er zum Aufnehmen des magnetfeldempfindlichen Bauelements geöffnet und anschließend wieder verschlossen werden kann.

Vorzugsweise weist ein zweiteiliger Isolator einen Formschluss und/oder einen Kraftschluss zwischen den zwei Teilen des Isolators auf, sodass er das magnetfeldempfindliche Bauelement vorteilhaft sicher umschließen kann und sich nicht ungewollt öffnet und/oder das magnetfeldempfindliche Bauelement wieder freigibt.

Vorzugsweise weist der Isolator gegenüber dem Material der Wicklung eine geringere Härte auf, wodurch eine etwaige Reibung zwischen dem Isolator und einer Wicklung vorteilhaft eher den Isolator als die Wicklung beschädigt.

Durch den Isolator kann vorteilhaft erreicht werden, dass das magnetfeldempfindliche Bauelement von der ersten Hauptwicklung und der Testwicklung sowie gegebenenfalls der zweiten Hauptwicklung regional getrennt ist, wodurch etwaig auftretende Schädigungen der Wicklungen reduziert werden können.

Sofern der Isolator eine geringere Härte und/oder einen geringeren E-Modul als das Material der Wicklungen von erster Hauptwicklung und Testwicklung und gegebenenfalls der zweiten Hauptwicklung aufweist, können die Wicklungen mit einer Vorspannkraft derart verlegt werden, dass sie eine elastische Verformung des Isolators und damit einen Formschluss zwischen Isolator und Wicklung hervorrufen, dass die Wicklungen relativ zueinander eine bessere Ortsfestigkeit erlangen, wodurch die Zuverlässigkeit des Sensors vorteilhaft steigen kann.

Weiterhin ermöglicht es der Isolator, dass ein beständig konstanter Abstand zwischen den Wicklungen und dem magnetfeldempfindlichen Bauelement erreicht werden kann. Hierdurch kann vorteilhaft erreicht werden, dass die physikalische Wirkverbindung zwischen den Wicklungen und dem magnetfeldempfindlichen Bauelement konstant bleibt. Damit kann die Präzision der Bestimmung eines Sensorsignals vorteilhaft dauerhaft aufrechterhalten bleiben.

Bevorzugt weist der Sensor eine zweite Hauptwicklung auf, wobei die zweite Hauptwicklung das magnetempfindliche Bauelement und/oder den Isolator mit einer Mehrzahl von Windungen umschließt.

Begrifflich sei hierzu Folgendes erläutert:
Unter einer "zweiten Hauptwicklung" wird eine Hauptwicklung verstanden, die neben einer ersten Hauptwicklung um ein magnetfeldempfindliches Bauelement gewickelt ist.

Vorzugsweise weist die zweite Hauptwicklung eine Wicklungsrichtung auf, die sich von der Wicklungsrichtung der ersten Hauptwicklung unterscheidet.

Beim designierten Betrieb eines Sensors gemäß dem ersten Aspekt der Erfindung aufweisend eine erste Hauptwicklung und keine zweite Hauptwicklung, wird die erste Hauptwicklung mit einer alternierenden Spannung versorgt, sodass der Stromfluss in der ersten Hauptwicklung mit jedem Vorzeichenwechsel der Versorgungsspannung auch das Vorzeichen umkehrt.

Alternativ wird die erste Hauptwicklung mit einer Stromquelle gespeist, welche alternierend die Stromrichtung umkehrt. Durch die Verwendung einer Stromquelle kann vorteilhaft eine höhere Messgenauigkeit des Sensors erreicht werden.

Mit anderen Worten weist die erste Hauptwicklung beim designierten Betrieb des Sensors zyklisch unterschiedliche Stromflussrichtungen auf.

Der zeitliche Verlauf des Stromflusses beim designierten Sensorbetrieb in der ersten Hauptwicklung kann sinusförmig oder rechteckförmig oder eine andere Schwingungsform aufweisen.

Der oszillierende Stromfluss in der ersten Hauptwicklung ist dazu eingerichtet, in dem magnetfeldempfindlichen Bauelement eine ebenfalls oszillierende magnetische Flussdichte zu induzieren.

Der hier vorgeschlagene Sensor weist zwei Hauptwicklungen auf, eine erste und eine zweite Hauptwicklung.

Vorzugsweise ist die Anzahl der Wicklung der zweiten Hauptwicklung gleich der Anzahl der Wicklungen der ersten Hauptwicklung.

Hierdurch ist es möglich, dass eine einzelne Hauptwicklung keine Vorzeichenwechsel in der Stromflussrichtung aufweisen muss, um den Sensor in designierter Art und Weise zu betreiben. Vielmehr können die beiden Hauptwicklungen jeweils gepulst betrieben werden, sodass sie alternierend zueinander einen Stromfluss und keinen Stromfluss aufweisen.

Sind die beiden Hauptwicklungen in unterschiedlicher Drehrichtung um das magnetfeldempfindliche Bauelement gewickelt, so kann eine alternierende magnetische Flussdichte in dem magnetfeldempfindlichen Bauelement induziert werden, indem die beiden Hauptwicklungen alternierend mit der gleichen Spannungsquelle oder Stromquelle verbunden werden, wobei die Spannungsquelle oder die Stromquelle einen stetigen konstanten Ausgangswert aufweisen kann. Dies ermöglicht vorteilhaft eine günstigere Gestaltung der Betriebsschaltung für den designierten Sensorbetrieb. Auch wenn eine zusätzliche Hauptwicklung benötigt wird, so kann hierdurch dennoch eine Reduktion der gemeinsamen Kosten für Sensor und Betriebsschaltung erreicht werden.

Vorzugsweise sind die Anzahl der Wicklungen der zweiten Hauptwicklung äquidistant über den gesamten Umlauf des magnetfeldempfindlichen Bauelements verteilt.

Vorzugsweise weist die zweite Hauptwicklung eine Windungsanzahl in einem Bereich zwischen 25 und 150 Wicklungen auf, bevorzugt eine Windungsanzahl in einem Bereich zwischen 35 und 135 Wicklungen, besonders bevorzugt eine Windungsanzahl in einem Bereich zwischen 40 und 130 Wicklungen. Weiterhin vorzugsweise weist die zweite Hauptwicklung eine Windungsanzahl in einem Bereich zwischen 45 und 125 Wicklungen auf, bevorzugt eine Windungsanzahl in einem Bereich zwischen 50 und 120 Wicklungen, besonders bevorzugt eine Windungsanzahl in einem Bereich von 60 bis 110 Wicklungen.

Vorteilhaft kann mit der hier vorgeschlagenen Anzahl von Windungen der zweiten Hauptwicklung erreicht werden, dass das magnetfeldempfindliche Bauelement mit möglichst äquidistantem Abstand zwischen den einzelnen Wicklungen umwickelt werden kann, damit sich beim Bestromen der zweiten Hauptwicklung eine möglichst lokal homogene magnetische Flussdichte in dem magnetfeldempfindlichen Bauelement einstellt.

Ausdrücklich sei darauf hingewiesen, dass die vorstehenden Werte für die Windungsanzahl der zweiten Hauptwicklung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Windungsanzahl der zweiten Hauptwicklung liefern.

Gemäß einer besonders zweckmäßigen Ausführungsform weist der Sensor einen Distanzring auf, wobei der Distanzring zwischen der Abschirmungsinnenwand und der ersten Hauptwicklung angeordnet ist.

Begrifflich sei hierzu Folgendes erläutert:
Unter einem "Distanzring" wird ein ringförmiges Bauelement verstanden, welches dazu eingerichtet ist, zwischen der Abschirmungsinnenwand und der ersten Hauptwicklung des Sensors angeordnet zu werden.

Vorzugsweise ist ein Distanzring dazu eingerichtet, den Radialspalt im Aufnahmeraum zwischen der Abschirmungsinnenwand und der Hauptwicklung zu reduzieren oder aufzufüllen.

Vorzugsweise ist ein Distanzring dazu eingerichtet, den Axialspalt zwischen einem ersten Abschirmungsteil und einem zweiten Abschirmungsteil aufzufüllen, sodass der Distanzring die Breite des umlaufenden Spalts definieren kann, sobald die zwei Abschirmungsteile jeweils an dem Distanzring anliegend angeordnet sind.

Vorzugsweise besteht der Distanzring aus Kunststoff oder einem anderen Material mit einer vergleichsweise geringen spezifischen Leitfähigkeit.

Vorteilhaft kann durch den Distanzring auch erreicht werden, dass die Drähte der Hauptwicklung und/oder der Testwicklung bei der Montage des Sensors geschützt werden. So kann der Distanzring mitsamt dem bereits mit der Hauptwicklung oder den Hauptwicklungen und der Testwicklung umwickelten magnetfeldempfindlichen Bauelement insbesondere in ein erstes Teil der Abschirmung eingelegt werden, insbesondre dasjenige Teil der Abschirmung, welches vorzugsweise von einem anderen Teil der Abschirmung an seiner Außenfläche zumindest teilweise designiert überlappt wird. So kann das magnetfeldempfindliche Bauelement unter optischer Kontrolle vorsichtig in das erste Teil der Abschirmung eingebracht werden, wobei das magnetfeldempfindliche Bauelement auf seiner Innenseite von dem Distanzring vor mechanischen Belastungen geschützt wird, insbesondere die um das magnetfeldempfindliche Bauelement angeordneten Wicklungen von dem Distanzring auf der Innenseite vor mechanischen Belastungen geschützt werden. Anschließend kann das zweite Teil der Abschirmung derart aufgesteckt werden, dass die Wicklungen bereits von dem Distanzring und dem überlappten ersten Teil der Abschirmung vor mechanischen Belastungen geschützt werden. Insofern kann auch bei der mangelnden optischen Zugänglichkeit der besonders empfindlichen Komponenten bei der Montage des zweiten Teils der Abschirmung bereits der mechanische Schutz der empfindlichen Komponenten durch den Distanzring vorteilhaft verbessert werden.

Bevorzugt wird hier ein Distanzring vorgeschlagen, der im Inneren seines Grundmaterials einen Einleger aus einem Werkstoff mit einer vergleichsweise hohen Permeabilität, insbesondere einer Permeabilität, welche im Wesentlichen der Permeabilität der Abschirmung entspricht, aufweist. Vorzugsweise wird dieser Einleger vollständig von dem Grundmaterial des Distanzrings umschlossen, damit er durch das Grundmaterial mit der vergleichsweise geringen elektrischen Leitfähigkeit isoliert wird.

Hierdurch kann vorteilhaft erreicht werden, dass die Leckage am umlaufenden Spalt des von dem magnetfeldempfindlichen Bauelement während dem designierten Betrieb des Sensors ausgehenden Magnetfelds in Folge der höheren Permeabilität des Distanzrings reduziert werden kann, wodurch die Messgenauigkeit des Sensors vorteilhaft gesteigert werden kann und auch der Energiebedarf des Sensors reduziert werden kann.

Optional weist die Abschirmung eine Beschichtung auf, insbesondere eine elektrisch isolierende Beschichtung.

Begrifflich sei hierzu Folgendes erläutert:
Unter einer "Beschichtung" wird eine festhaftende Schicht aus einem formlosen Stoff auf der Oberfläche der Abschirmung verstanden.

Vorzugsweise ist eine Beschichtung dazu eingerichtet, dass sie besonders schlecht für einen elektrischen Strom leitend ist. Eine Beschichtung weist also vorzugsweise eine besonders gering elektrische Leitfähigkeit auf.

Vorzugsweise besteht eine Beschichtung aus einem Epoxidharz.

Vorzugsweise ist die Beschichtung derart auf die Abschirmung aufgebracht, dass sie zumindest die Teilfläche der äußeren Abschirmungsfläche bedeckt, die designiert in der Nähe einer Leiterplatte angeordnet wird.

Vorteilhaft kann so eine Isolation der Abschirmung gegenüber einer designierten Leiterplatte erreicht werden, sodass ein Kurzschluss zwischen Abschirmung und designierter Leiterplatte vorteilhaft verhindert werden kann.

Gemäß einer zweckmäßigen Ausführungsform weist die Abschirmung eine Materialdicke in einem Bereich zwischen 0,25 mm und 0,45 mm auf, bevorzugt in einem Bereich zwischen 0,3 mm und 0,4 mm und besonders bevorzugt in einem Bereich zwischen 0,32 mm und 0,38 mm.

Begrifflich sei hierzu Folgendes erläutert:
Unter einer "Materialdicke" oder einer Materialstärke wird die Ausdehnung eines Körpers in Richtung seiner Flächennormalen verstanden.

Unter einem "Wirbelstrom" wird ein Strom verstanden, welcher in einem ausgedehnten elektrischen Leiter in einem sich zeitlich ändernden Magnetfeld und/oder in einem bewegten Leiter in einem zeitlich konstanten, dafür räumlich inhomogenen Magnetfeld induziert wird. Weist der Leiter einen endlichen elektrischen Widerstand auf, so erwärmt er sich in Folge des Wirbelstroms. Diese in Wärme umgewandelte Energiemenge wird als "Wirbelstromverlust" bezeichnet.

Hier wird vorgeschlagen, die Materialdicke einer Abschirmung eines magnetfeldempfindlichen Bauelements mitsamt der zumindest einen Hauptwicklung und der Testwicklung um das magnetfeldempfindliche Bauelement zu reduzieren.

Die Möglichkeit zur Reduktion der Materialdicke im Bereich der Abschirmung beruht auf einer Innovation im Bereich der Herstellung der Abschirmung.

Vorzugsweise ist die Abschirmung tiefgezogen oder spritzgegossen.

Hierdurch kann vorteilhaft eine Kosteneinsparung gegenüber einer dickeren Materialstärke der Abschirmung erreicht werden.

Beim designierten Betrieb des Sensors weist das magnetfeldempfindliche Bauelement eine oszillierende magnetische Flussdichte auf. Da auch die Abschirmung aus einem elektrisch gut leitfähigen Material besteht, erfährt sie durch die Änderung der magnetischen Flussdichte des magnetfeldempfindlichen Bauelements eine Induktionswirkung. Diese Induktionswirkung ist unerwünscht, da hierdurch Wirbelstromverluste entstehen.

Durch eine Reduktion der Materialdicke der Abschirmung können die beim designierten Betrieb des Sensors entstehenden Wirbelstromverluste vorteilhaft reduziert werden.

Hierdurch kann der Energiebedarf des Sensors vorteilhaft reduziert und die Messgenauigkeit des Sensors erhöht werden.

Ausdrücklich sei darauf hingewiesen, dass die vorstehenden Werte für die Materialdicke der Abschirmung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Materialdicke der Abschirmung liefern.

Bevorzugt weist der umlaufende Spalt eine Spaltbreite in einem Bereich zwischen 0,1 mm und 2,0 mm auf, bevorzugt in einem Bereich zwischen 0,3 mm und 1,7 mm und besonders bevorzugt in einem Bereich zwischen 0,6 mm und 1,3 mm.

Begrifflich sei hierzu Folgendes erläutert:
Unter einer "Spaltbreite" wird die Breite eines Spalts verstanden. Vorzugsweise wird unter der Breite des Spalts die Breite des umlaufenden Spalts auf der Abschirmungsinnenwand der Abschirmung verstanden.

Ein umlaufender Spalt in der Abschirmung ist besonders vorteilhaft, da die Abschirmung anderenfalls auch eine Wicklung aus einem elektrisch gut leitfähigen Material um das magnetfeldempfindliche Bauelement darstellen würde, welche im designierten Betrieb des Sensors, in welchem die magnetische Flussdichte in dem magnetfeldempfindlichen Bauelement oszilliert, eine stärkere Induktionswirkung erfahren würde. Hierdurch würden die Wirbelstromverluste im Zusammenhang mit der Abschirmung steigen, was zu einem höheren Energiebedarf des Sensors und zu einer reduzierten Messgenauigkeit des Sensors führen kann.

Ein umlaufender Spalt in der Abschirmung des Sensors führt nachträglich jedoch auch zu einer Senke in dem Magnetfeld um das magnetfeldempfindliche Bauelement, insbesondere da die Permeabilität von Luft in dem umlaufenden Spalt deutlich geringer ist als die Permeabilität der Abschirmung.

Somit führt auch eine zu große Breite des umlaufenden Spalts zu andersgearteten physikalischen Effekten, welche sich ebenfalls negativ auf den Energiebedarf des Sensors und die Messgenauigkeit des Sensors auswirken.

Hier wird nun ein spezifischer Bereich für die Spaltbreite des umlaufenden Spalts vorgeschlagen, wodurch vorteilhaft ein Optimum zwischen der mit einer zu geringen Breite des umlaufenden Spalts und der mit einer zu großen Breite des umlaufenden Spalts auf Basis unterschiedlicher physikalischer Effekte einhergehenden optimal sensitiven Messgenauigkeit des Sensors erreicht werden kann.

Weiterhin kann mit der hier vorgeschlagenen Breite des umlaufenden Spalts erreicht werden, dass der Energiebedarf für den Betrieb des Sensors vorteilhaft minimiert werden kann.

Ausdrücklich sei darauf hingewiesen, dass die vorstehenden Werte für die Spaltbreite des umlaufenden Spalts nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe des hier vorgeschlagenen Spaltbreite des umlaufenden Spalts liefern.

Gemäß einer zweckmäßigen Ausführungsform weist der Sensor einen elektrischen Verbinder auf, wobei der elektrische Verbinder eine Tragplatte, einen Verbinderhals und eine Mehrzahl von elektrischen Kontakten aufweist,
- wobei der elektrische Verbinder zumindest für jede Wicklung zwei elektrische Kontakte aufweist,
- wobei die elektrischen Kontakte in radialer Richtung außerhalb der Abschirmungsaußenwand angeordnet sind,
- wobei die Tragplatte zwischen der Abschirmungsaußenwand und der ersten Hauptwicklung angeordnet ist,
- wobei der Verbinderhals durch eine Öffnung in der Abschirmungsaußenwand verläuft und die Tragplatte und die elektrischen Kontakte miteinander verbindet,
- wobei die Tragplatte und der Verbinderhals jeweils eine korrespondierende Ausnehmung aufweisen, wobei die Ausnehmung dazu eingerichtet ist, die mit jeder Wicklung in einer Wirkverbindung stehenden zwei elektrischen Drähte aus dem Aufnahmeraum aufzunehmen und aus dem Aufnahmeraum durch die Öffnung in der Abschirmungsaußenwand zu den elektrischen Kontakten zu führen,
- wobei die Ausnehmung in einer Richtung parallel zu der Abschirmungsaußenwand eine Kerbe aufweist, durch welche die elektrischen Drähte in einen Zentralbereich der Ausnehmung eingelegt werden können.

Begrifflich sei hierzu Folgendes erläutert:
Unter einem "elektrischer Verbinder" wird ein Bauelement verstanden, welches zur Befestigung an dem Sensor eingerichtet ist und zumindest die benötigte Anzahl an zugänglichen elektrischen Kontakten aufweist.

Vorzugsweise ermöglicht es der Verbinder, dass die elektrischen und/oder elektronischen Bauelemente des Sensors mit den elektrischen Kontakten des Verbinders elektrisch verbunden werden können, wobei die elektrischen Kontakte des Verbinders eine vergleichsweise gute Zugänglichkeit aufweisen.

Vorzugsweise ermöglicht es der Verbinder zumindest mittelbar, dass die elektrischen Kontakte relativ zum Sensor ortsfest angeordnet werden können.

Insgesamt ermöglicht es der Verbinder somit vorzugsweise und vorteilhaft, dass der Sensor mit einer festgelegten relativen Anordnung zwischen dem magnetfeldempfindlichen Bauelement und den elektrischen Kontakten eingesetzt werden kann, wobei die elektronischen und/oder elektrischen Bauelemente des Sensors bereits bei der Herstellung des Sensors mit den elektrischen Kontakten elektrisch verbunden werden können.

Somit kann der Sensor unmittelbar durch verlöten oder mittelbar durch ein anderweitiges Kontaktelement, insbesondere einen Stecker, mittels der elektrischen Kontakte des elektrischen Verbinders vorteilhaft mit einer Platine verbunden werden, insbesondere dergestalt, dass die relative Position des magnetfeldempfindlichen Bauelements zu einer Platine durch die zumindest mittelbar durch den elektrischen Verbinder ermöglichte Verbindung festgelegt werden kann.

Vorzugsweise weist der elektrische Verbinder als Grundmaterial einen Kunststoff auf, insbesondere einen Kunststoff mit einer vergleichsweise geringen elektrischen Leitfähigkeit.

Vorzugsweise sind die elektrischen Kontakte des elektrischen Verbinders von dem Grundmaterial des Verbinders zumindest teilweise umschlossen, sodass zwischen dem Grundmaterial und den elektrischen Kontakten eine kraftschlüssige und/oder eine formschlüssige Verbindung besteht. Weiterhin vorzugsweise sind die elektrischen Kontakte durch das Grundmaterial des elektrischen Verbinders räumlich separiert voneinander angeordnet, wodurch vorteilhaft erreicht werden kann, dass kein direkter elektrischer Kontakt zwischen zwei elektrischen Kontakten besteht, sodass ein Kurzschluss zwischen den einzelnen elektrischen und/oder elektronischen Bauelementen des Sensors verhindert werden kann.

Unter einer "Tragplatte" wird ein Bereich des elektrischen Verbinders verstanden, welcher zur formschlüssigen und/oder kraftschlüssigen zumindest mittelbaren Verbindung zwischen dem magnetfeldempfindlichen Bauelement und dem elektrischen Verbinder eingerichtet ist.

Vorzugsweise kann die Tragplatte innerhalb des Aufnahmeraums der Abschirmung aufgenommen werden, insbesondre zwischen der Abschirmung und der Hauptwicklung, vorzugsweise zwischen der Hauptwicklung und der Abschirmungsaußenwand der Abschirmung.

Vorzugsweise ist die Tragplatte dazu eingerichtet, gemeinsam mit dem magnetfeldempfindlichen Bauelement und den das magnetfeldempfindliche Bauelement umgebenden Wicklungen in die Abschirmung eingebracht zu werden. Hierdurch kann vorteilhaft durch die Tragplatte ein zusätzlicher Schutz der Wicklungen vor mechanischen Belastungen beim Einbau in die Abschirmung erreicht werden.

Unter einem "Verbinderhals" wird ein Bereich des elektrischen Verbinders verstanden, der dazu eingerichtet ist, die Tragplatte und die elektrischen Kontakte miteinander zu verbinden.

Unter einem "elektrischen Kontakt" wird ein Bauelement des elektrischen Verbinders verstanden, welches zur Kontaktierung zwischen den elektrischen und/oder elektronischen Bauelementen des Sensors eingerichtet ist.

Vorzugsweise ist ein elektrischer Kontakt so ausgebildet, dass er aus dem Grundmaterial des elektrischen Verbinders in zwei Richtungen hervorsteht. Dabei sei insbesondere daran gedacht, dass an einem vorstehenden Ende des elektrischen Kontakts eine Kontaktierung zwischen den elektrischen und/oder elektronischen Bauelementen des Sensors und dem elektrischen Kontakt vorgenommen werden kann. Weiterhin sei daran gedacht, dass an einem abweichenden vorstehenden Ende des elektrischen Kontakts eine Kontaktierung mit einer Betriebsschaltung für den Sensor vorgenommen werden kann, insbesondere mittels verlöten oder mittels eines mit dem elektrischen Kontakt oder einer Mehrzahl von elektrischen Kontakten korrespondierenden Steckverbinders.

Vorzugsweise besteht ein elektrischer Kontakt aus einer Legierung, welche Nickel in einem Bereich zwischen 17 und 19 Gew.-% aufweist, bevorzugt Nickel in einem Bereich zwischen 17,5 und 18,5 Gew.-% und besonders bevorzugt 18 Gew.-% Nickel aufweist.

Vorzugsweise besteht ein elektrischer Kontakt aus einer Legierung, welche Zink in einem Bereich zwischen 18 und 22 Gew.-% aufweist, bevorzugt Zink in einem Bereich zwischen 19 und 21 Gew.-% und besonders bevorzugt 20 Gew.-% Zink aufweist.

Vorzugsweise besteht ein elektrischer Kontakt aus einer Legierung, welche größer gleich 58 Gew.-% Kupfer aufweist, bevorzugt größer gleich 60 Gew.-% Kupfer und besonderes bevorzugt größer gleich 61 Gew.-% Kupfer. Weiterhin bevorzugt besteht ein elektrischer Kontakt aus einer Legierung, welche größer gleich 62 Gew.-% Kupfer aufweist, weiterhin bevorzugt größer gleich 63 Gew.-% Kupfer und besonderes bevorzugt größer gleich 64 Gew.-% Kupfer.

Die oberhalb beschriebene Legierungszusammensetzung für die elektrischen Kontakte ermöglicht vorteilhaft eine sehr gute elektrische Leitfähigkeit bei einem gleichzeitig vergleichsweise hohen Elastizitätsmodul und sehr guten Tauchverzinnungseigenschaften und Löteigenschaften.

Ausdrücklich sei darauf hingewiesen, dass die vorstehenden Werte für die Legierungszusammensetzung eines elektrischen Kontakts nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Legierungszusammensetzung eines elektrischen Kontakts liefern.

Vorzugsweise weist ein elektrischer Kontakt eine Goldbeschichtung auf, wodurch vorteilhaft die elektrische Leitfähigkeit des elektrischen Kontakts verbessert werden kann.

Unter einer "Öffnung" wird ein Bereich in der Abschirmung verstanden, durch welchen der Verbinderhals des elektrischen Verbinders, welcher die Tragplatte und die elektrische Kontakte miteinander verbindet, sich aus dem Aufnahmeraum innerhalb der Abschirmung in einen Bereich außerhalb der Abschirmung erstrecken kann, sodass die elektrischen Kontakte des elektrischen Verbinders außerhalb der Abschirmung angeordnet sein können. Hierzu weist die Abschirmung vorzugsweise eine zu dem Verbinderhals korrespondierende Öffnung auf.

Im Fall einer zweiteiligen Abschirmung sei daran gedacht, dass eine oder beide Teile der Abschirmung eine Aussparung aufweisen, die nach dem Fügen der Abschirmungsteile die Öffnung ausbilden.

Vorzugsweise befindet sich die Öffnung im Bereich der Abschirmungsaußenwand.

Unter einer "Ausnehmung" wird ein Bereich im Querschnitt eines Bauelements verstanden, welcher nicht von dem Grundmaterial des Bauelements ausgebildet ist und somit von anderen Körpern durchdrungen werden kann, ohne das Bauelement dabei beschädigen zu müssen.

Vorzugsweise ist eine Ausnehmung ein Kanal durch das Grundmaterial des Bauelements.

Weiterhin vorzugsweise ist eine Ausnehmung in Form einer Senke in dem Grundmaterial des Bauelements ausgebildet, sodass ein anderer Körper durch die Öffnung der Senke in die Ausnehmung eingelegt werden kann.

Unter einer "korrespondierenden Ausnehmung" in dem Verbinderhals und der Tragplatte wird verstanden, dass die Ausnehmung mit einem im wesentlichen gleichbleibenden Verlauf in der Haupterstreckungsrichtung der Ausnehmung sowohl durch die Tragplatte als auch durch den Verbinderhals verläuft.

Unter einem "elektrischen Draht" wird ein gegenüber seiner Längserstreckung dünnes und biegsames Metall verstanden. Vorzugsweise weist ein elektrischer Draht einen kreisförmigen Querschnitt auf. Vorzugsweise weist ein elektrischer Draht eine Mehrzahl von Litzen auf. Vorzugsweise weist ein Draht einen hohen Kupferanteil auf.

Unter einer "Kerbe" wird ein spitz zulaufender oder keilförmiger Einschnitt verstanden.

Sensoren gemäß dem ersten Aspekt der Erfindung weisen eine Mehrzahl von elektrischen und/oder elektronischen Bauelementen auf. Während dem designierten Betrieb des Sensors stellen sich Ströme in den elektronischen und/oder elektrischen Bauelementen ein oder werden aktiv in die Bauelemente eingespeist.

Diese elektrischen und/oder elektronischen Bauelemente des Sensors sind designiert in dem Aufnahmeraum der Abschirmung angeordnet und müssen von außerhalb der Abschirmung elektrisch kontaktiert werden.

Die einfachste Form der elektrischen Kontaktierung beruht darauf, dass elektrische Drähte, die mit den elektrischen und/oder elektronischen Bauelementen verbunden sind, durch die Abschirmung hindurch nach außen geführt werden und außerhalb mit einer Leiterplatte verlötet werden, welche die Betriebsschaltung für den Sensor aufweist.

Bei dieser Lösung besteht eine Vielzahl von unterschiedlichen Schadensquellen für die elektrischen Drähte und somit auch gesamtheitlich für den Sensor, die zum Ausfall des Sensors führen können. Einerseits können die elektrischen Drähte, die meist nur einen sehr geringen Leiterquerschnitt aufweisen, aufgrund von mechanischen Belastungen leicht zerstört werden, insbesondere von Scherbelastungen im Bereich der Abschirmung oder von Zugbelastungen zwischen den Wicklungen und der Verbindung der elektrischen Drähte mit der Leiterplatte. Derartige Zugbelastungen können während der Montage des Sensors oder auch im Betrieb des Sensors auftreten, wenn es zu Relativbewegungen zwischen dem magnetfeldempfindlichen Bauelement und der Kontaktierung zwischen den elektrischen Drähten und der Leiterplatte kommt.

Hier wird vorgeschlagen, die elektrischen Drähte des Sensors sowohl mechanisch als auch elektrisch mittels eines elektrischen Verbinders verbindbar zu machen und damit die Robustheit und die Verfügbarkeit des Sensors vorteilhaft zu erhöhen.

Der hier vorgeschlagene elektrische Verbinder weist eine Tragplatte auf, die im Inneren des Aufnahmeraums der Abschirmung angeordnet ist. Ausgehend von der Tragplatte erstreckt sich als ein zweiter Bereich des elektrischen Verbinders der Verbinderhals. Der Verbinderhals erstreckt sich insbesondere durch die Abschirmung hindurch, insbesondere im Bereich der Abschirmungsaußenwand. An den Verbinderhals schließt sich eine Mehrzahl von elektrischen Kontakten an, welche zur elektrischen Kontaktierung mit den elektrischen und/oder elektronischen Komponenten des Sensors eingerichtet sind.

Die Tragplatte ermöglicht eine kraftschlüssige und/oder formschlüssige Verbindung des elektrischen Verbinders mit dem Sensor, insbesondere mit der Abschirmung des Sensors.

Der Verbinderhals ist dazu eingerichtet die elektrischen Drähte aufzunehmen und damit vor mechanischen Belastungen insbesondere im Bereich der Abschirmung zu schützen. Hierzu weisen der Verbinderhals und die Tragplatte eine korrespondierende Ausnehmung auf, in welche die elektrischen Drähte eingebracht werden können und welche die elektrischen Drähte vor einer äußeren mechanischen Belastung schützt.

Weiterhin legt der Verbinderhals die Relativposition zwischen dem magnetfeldempfindlichen Bauelement des Sensors und den zur elektrischen Kontaktierung eingerichteten elektrischen Kontakten fest. Die elektrischen Drähte können durch die korrespondierende Ausnehmung in dem Verbinderhals und der Tragplatte hindurch bis zu den elektrischen Kontakten geführt werden und dort mit den elektrischen Kontakten zur Kontaktierung verbunden werden.

Die korrespondierende Ausnehmung in dem Verbinderhals und der Tragplatte ist in Form einer Mulde ausgeformt, welche in einer Richtung quer zur Längserstreckungsrichtung der korrespondierenden Ausnehmung geöffnet ist, sodass die elektrischen Drähte sowohl in Längsrichtung und auch quer zur Längsrichtung in die Ausnehmung eingeführt werden können. Diese Bauform ermöglicht Vorteile bei dem Zusammenbau des Sensors, da die Drähte sowohl nach und nach einzeln als auch gebündelt sowohl in Längsrichtung als auch quer zur Längsrichtung in die Ausnehmung eingebracht werden können, wodurch es erheblich erleichtert wird, die elektrischen Drähte in die Ausnehmung zu verlegen.

Die korrespondierende Ausnehmung in dem Verbinderhals und der Tragplatte weist eine Kerbe auf, welche sich quer zur Längsachse der korrespondierenden Ausnehmung erstreckt und wobei die Spitze der Kerbe in Richtung der Ausnehmung zeigt. Mittels der Kerbe wird es ermöglicht elektrische Drähte einzeln oder in Bündeln auf eine einfache Art und Weise quer in die Ausnehmung einzulegen, wobei dabei die Kerbe an ihrer Engstelle von jedem einzelnen elektrischen Draht passiert werden muss. Die Engstelle der Kerbe ist dazu eingerichtet, dass ein elektrischer Draht, wenn er einmal in die Ausnehmung eingelegt ist, nur mit größerem Aufwand wieder quer zur Längsrichtung der Ausnehmung die Ausnehmung verlassen kann und damit designiert im Schutzbereich der Ausnehmung verbleibt. Hierdurch kann die sequenzielle Montage der elektrischen Drähte vereinfacht werden und sichergestellt werden, dass ein elektrischer Draht bereits nach dem Einlegen in die Ausnehmung von allen Seiten vor mechanischen Belastungen geschützt ist.

Nach einem zweiten Aspekt der Erfindung löst die Aufgabe ein Schutzschalter zum Unterbrechen eines Stromkreises bei Differenzströmen in dem Stromkreis die einen Grenzwert überschreiten aufweisend einen Sensor nach dem ersten Aspekt der Erfindung, eine Betriebsschaltung, eine elektronische Datenverarbeitungs- und -auswerteeinheit und eine Schaltvorrichtung,
- wobei der Sensor um zumindest zwei elektrische Leiter herum angeordnet ist, die einen Stromkreis bilden,
- wobei die Schaltvorrichtung zum Unterbrechen des Stromkreises eingerichtet ist,
- wobei die Betriebsschaltung zum Betrieb des Sensors eingerichtet ist,
- wobei die elektronische Datenverarbeitungs- und -auswerteeinheit zur Auswertung von Sensorsignalen des Sensors eingerichtet ist,
- wobei die elektronische Datenverarbeitungs- und -auswerteeinheit dazu eingerichtet ist, bei Erkennung eines elektrischen Differenzstroms, insbesondere bei allstromsensitiver Erkennung eines Differenzstroms, mit einer Stromstärke größer eines Grenzwertes, insbesondere eines einstellbaren Grenzwertes, die Schaltvorrichtung derart anzusteuern, dass die Schaltvorrichtung den Stromkreis unterbricht.

Begrifflich sei hierzu Folgendes erläutert:
Unter einem "Schutzschalter" wird eine Vorrichtung verstanden, welche beim Überschreiten eines definierten Differenzstroms, insbesondere beim Überschreiten eines einstellbaren Differenzstroms, in dem von dem Schutzschalter überwachten Stromkreis dazu eingerichtet ist, die Spannung des überwachten Stromkreises abzuschalten. Auf diese Weise kann vorteilhaft die Gefahr von Differenzströmen auf Mensch und Infrastruktur reduziert werden.

Unter einer "Betriebsschaltung" wird eine Schaltung zum aktiven oder passiven Betrieb des Sensors verstanden. Vorzugsweise ist eine Betriebsschaltung dazu eingerichtet, die erste Hauptwicklung und/oder die zweite Hauptwicklung eines Sensors mit einer Spannung zu versorgen.

Weiterhin ist eine Betriebsschaltung vorzugsweise dazu eingerichtet, die Spannung an der Testwicklung des Sensors abzugreifen und als Signal an die Datenerfassungs- und -auswerteeinheit weiterzugeben.

Ebenfalls ist die Betriebsschaltung vorzugsweise dazu eingerichtet, die Spannung an der ersten Hauptwicklung und/oder der zweiten Hauptwicklung des Sensors abzugreifen und als Signal an die Datenerfassungs- und -auswerteeinheit weiterzugeben.

Vorzugsweise sei auch daran gedacht, dass die Betriebsschaltung eine Stromaufnahmemesseinrichtung aufweist, welche dazu eingerichtet ist, die Stromaufnahme der Testwicklung und/oder der ersten Hauptwicklung und/oder einer zweiten Hauptwicklung zu bewerten.

Eine "elektronische Datenverarbeitungs- und -auswerteeinheit" ist eine elektronische Einheit, die organisiert mit Datenmengen umgeht und dabei das Ziel verfolgt, Informationen über diese Datenmengen zu gewinnen oder diese Datenmengen zu verändern. Dabei werden die Daten in Datensätzen erfasst, nach einem vorgegebenen Verfahren durch Mensch oder Maschine verarbeitet und als Ergebnis ausgegeben.

Unter "Daten" werden insbesondere Messwerte, insbesondere Sensorsignale, oder andere Werte physikalischer oder chemischer Messgrößen oder Größen verstanden.

Unter einer "Schaltvorrichtung" wird eine Vorrichtung verstanden, die dazu eingerichtet ist, die Spannungsversorgung für einen Stromkreis, insbesondere den von dem Schutzschalter überwachten Stromkreis, abzuschalten.

Unter einem "Stromkreis" wird ein elektrischer Stromkreis aus einem System von Leitern verstanden, welches einen geschlossenen Weg darstellt.

Unter einem "Sensorsignal" wird eine von dem Sensor bereitgestellt Zustandsgröße verstanden. Insbesondere ist ein Sensorsignal dazu eingerichtet, dass aus dem Sensorsignal mittels einer physikalischen und/oder chemischen Abhängigkeit auf einen Differenzstrom in dem von dem Sensor überwachten Stromkreis geschlossen werden kann. Vorzugsweise kann der Differenzstrom in dem von dem Sensor überwachten Stromkreis direkt aus dem Sensorsignal berechnet werden. Vorzugsweise ist das Sensorsignal eine bestimmbare Stromstärke und/oder eine bestimmbare Spannung.

Unter der "Stromstärke" wird die elektrische Stromstärke verstanden, welche in Form einer physikalischen Größe den elektrischen Strom bemisst, insbesondere den elektrischen Strom in einem elektrischen Stromkreis. Die Stromstärke bezieht sich dabei auf eine geeignet orientierte Fläche, vorzugsweise die Querschnittsfläche eines elektrischen Leiters. In diesem Fall ist die Stromstärke die durch den Querschnitt geflossene und auf die betrachtete Zeitspanne bezogene Ladungsmenge.

Vorzugsweise wird unter einem Sensorsignal die Stromaufnahme der ersten Hauptwicklung verstanden, welche mittels einer mathematischen Vorschrift in einen Differenzstrom überführt werden kann.

Unter einem "Grenzwert" wird ein definierter Wert einer Zustandsgröße, insbesondere des Differenzstroms, verstanden, ab dessen Überschreiten in dem von dem Schutzschalter überwachten Stromkreis die Schaltvorrichtung spätestens die Spannungsversorgung des mittels des Schutzschalters überwachten Stromkreises abschalten muss. Vorzugsweise kann der Grenzwert des Schutzschalters einstellbar sein.

Hier wird also konkret ein Schutzschalter vorgeschlagen, welcher einen Sensor nach dem ersten Aspekt der Erfindung zur Überwachung des Stromkreises nutzt.

Es versteht sich, dass sich die Vorteile eines Sensors zum Bestimmen eines elektrischen Differenzstroms nach dem ersten Aspekt der Erfindung wie vorstehend beschrieben unmittelbar auf einen Schutzschalter aufweisend einen Schutzschalter nach dem ersten Aspekt der Erfindung erstrecken.

Insbesondere kann hierdurch vorteilhaft ein Schutzschalter mit einer höheren Sensitivität für Differenzströme erreicht werden, sodass der Schutzschalter bereits bei sehr geringen Differenzströmen in dem überwachten Stromkreis den Stromkreis unterbrechen kann. Weiterhin kann dabei gleichzeitig vorteilhaft erreicht werden, dass der Schutzschalter eine besonders geringe Wahrscheinlichkeit für ein fehlerhaftes Detektieren eines vermeintlich einen Grenzstrom überschreitenden Differenzstrom beim Einschalten eines überwachten Stromkreises aufweist.

Es sei ausdrücklich darauf hingewiesen, dass der Gegenstand des zweiten Aspekts mit dem Gegenstand des vorstehenden Aspekts der Erfindung vorteilhaft kombinierbar ist, und zwar sowohl einzeln oder in beliebiger Kombination kumulativ.

Nach einem dritten Aspekt der Erfindung löst die Aufgabe ein Ladekabel zum Laden eines Elektrofahrzeuges, wobei das Ladekabel einen Sensor nach dem ersten Aspekt der Erfindung und/oder einen Schutzschalter nach dem zweiten Aspekt der Erfindung aufweist.

Begrifflich sei hierzu Folgendes erläutert:
Unter einem "Ladekabel" wird eine elektrische Verbindung verstanden, welche zum Verbinden eines Elektrofahrzeuges mit einer Stromquelle eingerichtet ist, wobei das Ladekabel zum Aufladen einer Traktionsbatterie des Elektrofahrzeugs eingerichtet ist. Vorzugsweise weist das Ladekabel eine Überwachungseinrichtung für etwaige Differenzströme auf.

Unter einem "Elektrofahrzeug" wird ein zumindest teilweise durch einen elektrischen Motor angetriebenes Fahrzeug verstanden. Vorzugsweise ist ein Elektrofahrzeug nicht an eine Schiene gebunden oder zumindest nicht dauerhaft spurgebunden.

Hier wird ein Ladekabel zum Laden einer Batterie eines Elektrofahrzeugs vorgeschlagen, welches einen Schutzschalter nach dem zweiten Aspekt der Erfindung und/oder einen Sensor nach dem ersten Aspekt der Erfindung aufweist.

Es versteht sich, dass sich die Vorteile eines Sensors zum Bestimmen eines elektrischen Differenzstroms nach dem ersten Aspekt der Erfindung und/oder eines Schutzschalters zum Unterbrechen eines Stromkreises bei Differenzströmen in dem Stromkreis die einen Grenzwert überschreiten nach dem zweiten Aspekt der Erfindung wie vorstehend beschrieben unmittelbar auf ein Ladekabel zum Laden eines Elektrofahrzeuges, wobei das Ladekabel einen Sensor nach dem ersten Aspekt der Erfindung und/oder einen Schutzschalter nach dem zweiten Aspekt der Erfindung aufweist, erstrecken.

Es sei ausdrücklich darauf hingewiesen, dass der Gegenstand des dritten Aspekts mit dem Gegenstand des vorstehenden Aspekts der Erfindung vorteilhaft kombinierbar ist, und zwar sowohl einzeln oder in beliebiger Kombination kumulativ.

Nach einem vierten Aspekt der Erfindung löst die Aufgabe eine Ladestation zum Laden von Elektrofahrzeugen, wobei die Ladestation einen Sensor nach dem ersten Aspekt der Erfindung und/oder einen Schutzschalter nach dem zweiten Aspekt der Erfindung aufweist.

Begrifflich sei hierzu Folgendes erläutert:
Unter einer "Ladestation" oder auch einer "Wandladestation" wird ein Ladegerät zum Aufladen von Elektrofahrzeugen verstanden. Im Fall einer Wandladestation ist die Ladestation insbesondere dazu eingerichtet, um an einer Wand befestigt zu werden. Vorzugsweise ist eine Ladestation ein mobiles Gerät, welches variabel an unterschiedlichen Standorten aufgestellt werden kann. Vorzugsweise stellt eine Ladestation oder eine Wandladestation neben einer Steckverbindung für ein Ladekabel zum Verbinden der Ladestation mit dem Elektrofahrzeug und einer Verbindung zum elektrischen Versorgungsnetz auch weitere Funktionen zur Verfügung, insbesondere eine Überwachungseinrichtung für etwaige Differenzströme.

Hier wird eine Ladestation zum Laden eines Elektrofahrzeugs vorgeschlagen, welches einen Schutzschalter nach dem zweiten Aspekt der Erfindung und/oder einen Sensor nach dem ersten Aspekt der Erfindung aufweist.

Es versteht sich, dass sich die Vorteile eines Sensors zum Bestimmen eines elektrischen Differenzstroms nach dem ersten Aspekt der Erfindung und/oder eines Schutzschalters zum Unterbrechen eines Stromkreises bei Differenzströmen in dem Stromkreis die einen Grenzwert überschreiten nach dem zweiten Aspekt der Erfindung wie vorstehend beschrieben unmittelbar auf eine Ladestation zum Laden von Elektrofahrzeugen, wobei die Ladestation einen Sensor nach dem ersten Aspekt der Erfindung und/oder einen Schutzschalter nach dem zweiten Aspekt der Erfindung aufweist, erstrecken.

Es sei ausdrücklich darauf hingewiesen, dass der Gegenstand des vierten Aspekts mit dem Gegenstand des vorstehenden Aspekts der Erfindung vorteilhaft kombinierbar ist, und zwar sowohl einzeln oder in beliebiger Kombination kumulativ.

Weitere Vorteile, Einzelheiten und Merkmale der Erfindung ergeben sich nachfolgend aus den erläuterten Ausführungsbeispielen. Dabei zeigen im Einzelnen:
- Figur 1:: schematisch eine Anordnung des erfindungsgemäßen Sensors in einem Stromkreis;
- Figur 2:: schematisch eine physikalische Wirkverbindung beim Einschalten des Stromkreises;
- Figur 3:: schematisch eine dynamische Entwicklung der magnetischen Flussdichte über der Zeit beim Einschalten des Stromkreises an einer exemplarischen Stelle im magnetfeldempfindlichen Bauelement;
- Figur 4:: schematisch den physikalischen Zusammenhang zwischen lichter Weite des magnetfeldempfindlichen Bauelements, dem Verlauf der Neigung des fehlerhaften Auslösens eines Sensors in Abhängigkeit der lichten Weite und dem Verlauf des kleinsten messbaren Differenzstroms eines Sensors in Abhängigkeit der lichten Weite;
- Figur 5:: schematisch einen erfindungsgemäßen Sensor in einem Querschnitt;
- Figur 6: schematisch einen elektrischen Verbinder in unterschiedlichen Ansichten.

In der nun folgenden Beschreibung bezeichnen gleiche Bezugszeichen gleiche Bauteile bzw. gleiche Merkmale, sodass eine in Bezug auf eine Figur durchgeführte Beschreibung bezüglich eines Bauteils auch für die anderen Figuren gilt, sodass eine wiederholende Beschreibung vermieden wird. Ferner sind einzelne Merkmale, die in Zusammenhang mit einer Ausführungsform beschrieben wurden, auch separat in anderen Ausführungsformen verwendbar.

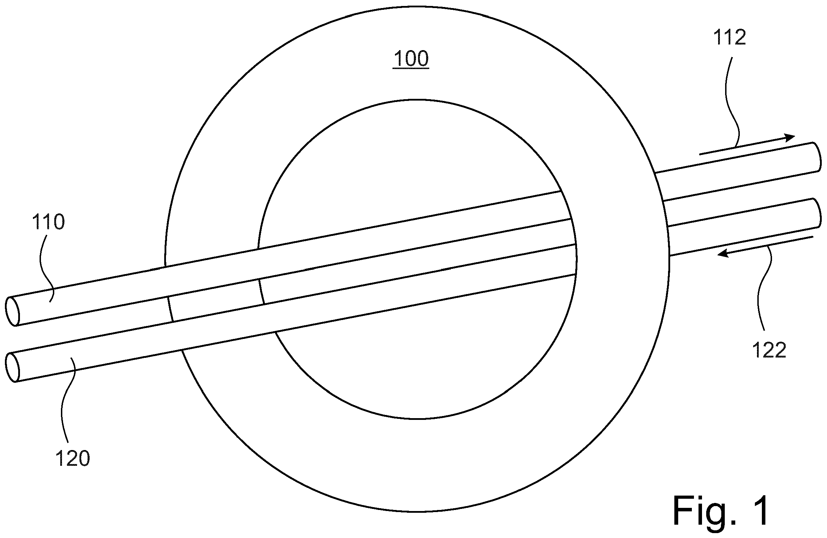

Der schematisch abgebildete Sensor 100 in Figur 1 ist um die elektrischen Leiter 110, 120 angeordnet, durch welche ein designierter elektrischer Strom 112, 114 in den von dem Sensor 100 überwachten Stromkreis (nicht abgebildet) einströmt und wieder ausströmt.

Dabei strömt der elektrische Strom 112 über den Außenleiter 110 in den von dem Sensor 100 überwachten Stromkreis (nicht abgebildet) ein und über den Neutralleiter 120 wieder aus.

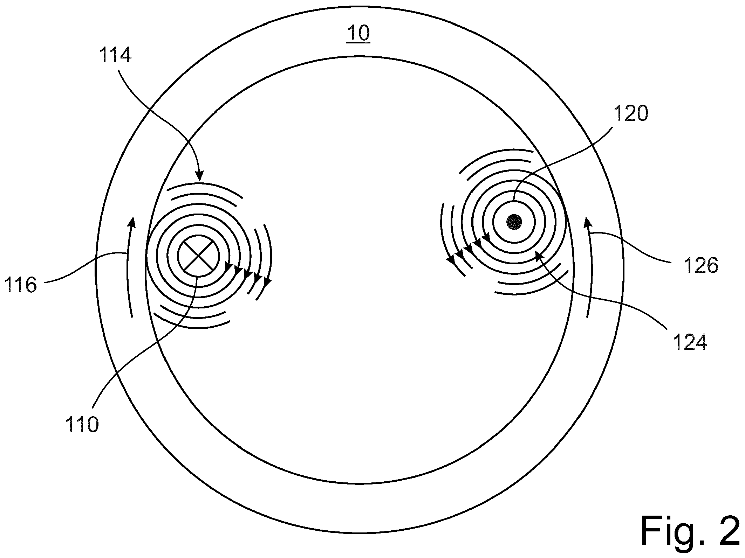

Beim Einschalten der Spannungsversorgung (nicht abgebildet) in einem Stromkreis (nicht abgebildet) tritt eine dynamische Physikalische Wirkverbindung in Figur 2 zwischen den sich um die elektrischen Leiter 110, 120 einstellenden magnetischen Feldern 114, 124 und der regionalen magnetischen Flussdichte 116, 118 in dem magnetfeldempfindlichen Bauelement 10 auf.

Die von den elektrischen Leitern 110, 120 ausgehenden magnetischen Felder 114, 124 beeinflussen das magnetfeldempfindliche Bauelement 10 beim Einschalten der Spannungsversorgung (nicht abgebildet) regional und zeitlich beschränkt auf unterschiedliche Art und Weise, sodass sich kurzfristig regional gegenläufige magnetische Flussdichten 116, 126 in dem magnetfeldempfindlichen Bauelement 10 einstellen.

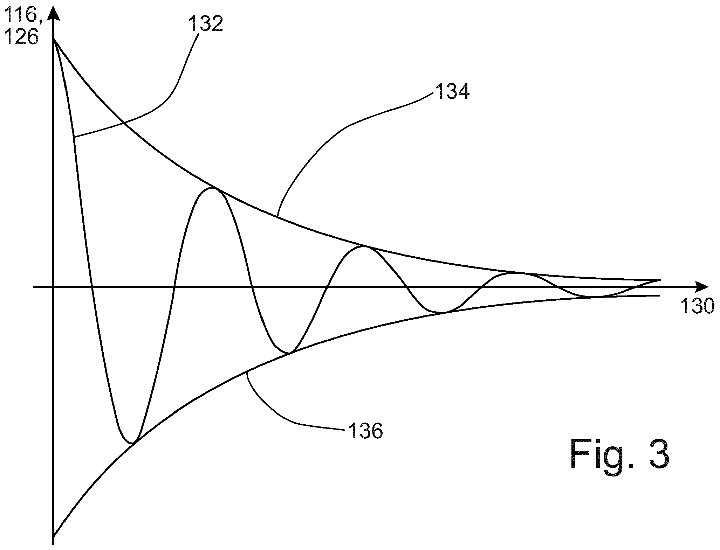

Die kurzfristigen regional gegenläufigen magnetischen Flussdichten 116, 126 in dem magnetfeldempfindlichen Bauelement 10 führen während ihres Ausgleichsvorganges in Figur 3 über der Zeit 130 an einer exemplarischen Stelle (nicht abgebildet) in dem magnetfeldempfindlichen Bauelement 10 betrachtet zu einem dynamischen Verhalten der magnetischen Flussdichte in Form einer Schwingung der magnetischen Flussdichte 132.

Diese Schwingung der magnetischen Flussdichte 132 als Folge des Einschaltens der Stromversorgung (nicht abgebildet) für den betrachteten Stromkreis (nicht abgebildet) verläuft gedämpft und nähert sich entlang der Asymptoten 132, 134 ihrem zeitlichen Grenzwert an.

Die kurzfristige Schwingung der magnetischen Flussdichte 132 führt dabei auch zu einer physikalischen Wechselwirkung (nicht abgebildet) mit der Testwicklung (nicht abgebildet) und/oder der ersten Hauptwicklung und/oder einer zweiten Hauptwicklung, wodurch ein Sensorsignal (nicht abgebildet) entsteht, was als ein Differenzstrom (nicht abgebildet) interpretiert werden kann, welcher einen definierten Grenzwert (nicht abgebildet) überschreitet. Dies kann auch als Einschaltfehler beschrieben werden.

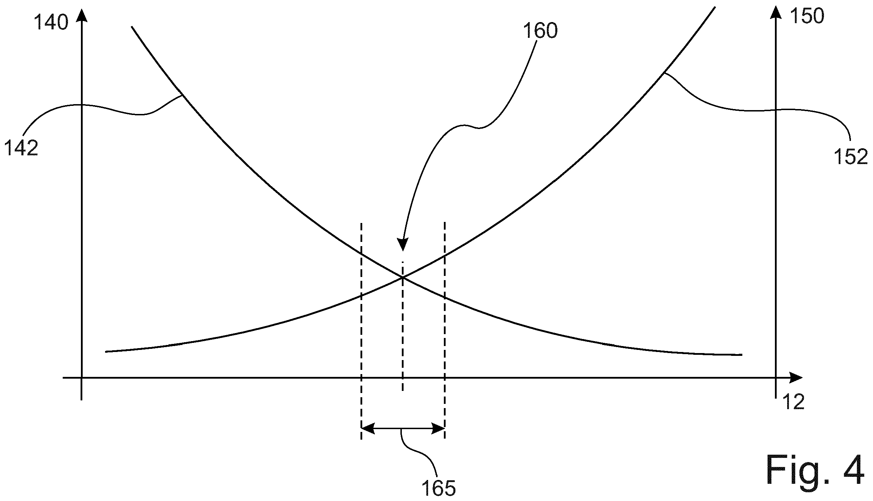

Der in Figur 4 dargestellte Zusammenhang zwischen der lichten Weite 12 der Durchgangsöffnung (nicht abgebildet) des magnetfeldempfindlichen Bauelements 10, der Neigung des fehlerhaften Auslösens 140 eines den Sensor 100 designiert verwendenden Schutzschalters (nicht abgebildet) und des kleinsten mit dem Sensor 100 messbaren Differenzstroms 150 zeigt auf, dass es einen optimalen Wert 160 für die lichte Weite 12 der Durchgangsöffnung (nicht abgebildet) des magnetfeldempfindlichen Bauelements 10 gibt, an welchem ein guter Kompromiss zwischen kleinstem messbaren Differenzstrom 150 und Neigung des fehlerhaften Auslösens 140 gefunden ist.

Dieser Optimalwert 160 liegt in der hier vorgelegten schematischen Betrachtung an dem Schnittpunkt der Verläufe 142, 152. Weiterhin ergibt sich ein optimaler Bereich 165 für die lichte Weite 12 der Durchgangsöffnung (nicht abgebildet) des magnetfeldempfindlichen Bauelements 10, welcher um den Optimalwert 160 herum angeordnet ist.

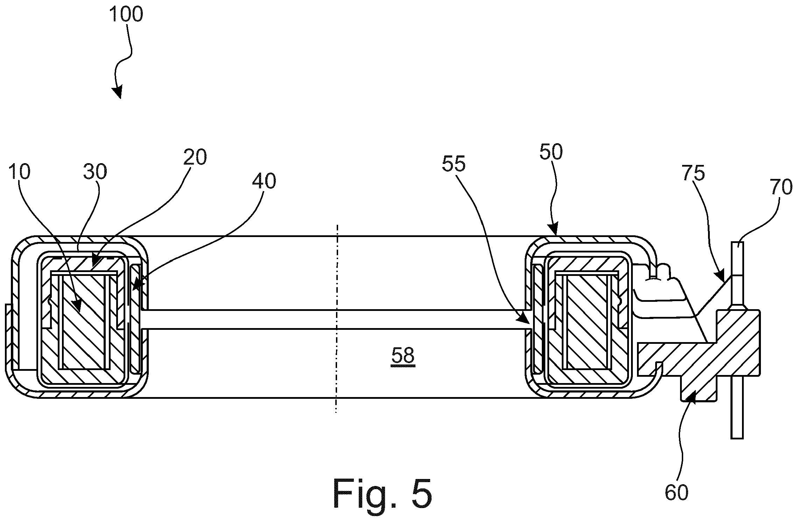

Der Sensor 100 in Figur 5 besteht im Wesentlichen aus einem magnetfeldempfindlichen Bauelement 10, einem das magnetfeldempfindliche Bauelement 10 umgebenden Isolator 20, einer Hauptwicklung 30, einer Testwicklung (nicht abgebildet), einem Distanzring 40, eine Abschirmung 50, einem elektrischen Verbinder 60 und einer Mehrzahl von elektrischen Kontakten 70.

Der Isolator 20 ist zweiteilig ausgebildet, wobei die einzelnen Teile (nicht bezeichnet) des Isolators 20 formschlüssig miteinander verbunden sind.

Die Hauptwicklung 30 ist mittels dem elektrischen Draht 75 an den elektrischen Kontakt 70 angeschlossen, welcher von dem elektrischen Verbinder 60 getragen wird.

Die Abschirmung 50 ist zweiteilig ausgebildet und formt einen umlaufenden Spalt 55 auf der Abschirmungsinnenwand 58 aus.

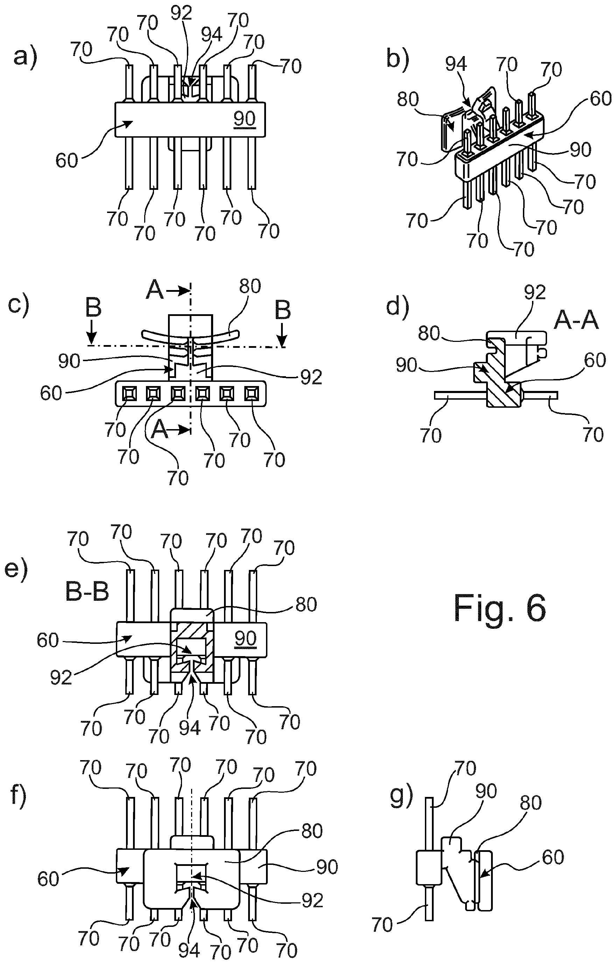

Der elektrische Verbinder 60 in Figur 6 besteht im Wesentlichen aus einer Tragplatte 80, einem Verbinderhals 90 und einer Mehrzahl von elektrischen Kontakten 70.

Unter lit. b) in Figur 6 ist eine dreidimensionale Ansicht auf den elektrischen Verbinder 60 dargestellt.

Unter lit. a) in Figur 6 ist eine Frontalansicht auf den elektrischen Verbinder 60 dargestellt, wobei die Frontalansicht, bezogen auf den designierten Sensor, von außen betrachtet dargestellt ist.

Unter lit. c) in Figur 6 ist eine Draufsicht auf den elektrischen Verbinder 60 dargestellt. Weiterhin sind die Schnittführungen A-A und B-B dargestellt.

Unter lit. d) ist der Schnitt A-A durch den elektrischen Verbinder 60 dargestellt.

Unter lit. e) ist der Schnitt B-B durch den elektrischen Verbinder 60 dargestellt.

Unter lit. f) in Figur 6 ist eine Frontalansicht auf den elektrischen Verbinder 60 dargestellt, wobei die Frontalansicht, bezogen auf den designierten Sensor, von innen betrachtet dargestellt ist.

Unter lit. g) in Figur 6 ist eine Seitenansicht auf den elektrischen Verbinder 60 dargestellt.

Die Tragplatte 80 ist dazu eingerichtet in dem Aufnahmeraum (nicht abgebildet) der Abschirmung (nicht abgebildet) aufgenommen zu werden.

Der Verbinderhals 90 verbindet die Mehrzahl von elektrischen Kontakten 70 mit der Tragplatte 80.

Der Verbinderhals 90 weist eine Ausnehmung 92 auf, die dazu eingerichtet ist, die mit jeder Wicklung (nicht abgebildet) in einer Wirkverbindung stehenden zwei elektrischen Drähte (nicht abgebildet) aus dem Aufnahmeraum (nicht abgebildet) aufzunehmen und aus dem Aufnahmeraum (nicht abgebildet) durch die Öffnung (nicht abgebildet) in der Abschirmungsaußenwand (nicht abgebildet) zu den elektrischen Kontakten (70) zu führen.

Die Ausnehmung 92 weist ferner in einer Richtung parallel zu der Abschirmungsaußenwand (nicht abgebildet) eine Kerbe 94 auf, durch welche die elektrischen Drähte (nicht abgebildet) in einen Zentralbereich (nicht bezeichnet) der Ausnehmung 92 eingelegt werden können.

Mittels der Kerbe 94 wird es ermöglicht, elektrische Drähte (nicht abgebildet) einzeln oder in Bündeln auf eine einfache Art und Weise quer in die Ausnehmung 92 einzulegen, wobei dabei die Kerbe 94 an ihrer Engstelle (nicht bezeichnet) von jedem einzelnen elektrischen Draht (nicht abgebildet) passiert werden muss. Die Engstelle (nicht bezeichnet) der Kerbe 94 ist dazu eingerichtet, dass ein elektrischer Draht (nicht abgebildet), wenn er einmal in die Ausnehmung 92 eingelegt ist, nur mit größerem Aufwand wieder quer zur Längsrichtung (nicht bezeichnet) der Ausnehmung 92 die Ausnehmung 92 verlassen kann und damit designiert im Schutzbereich (nicht bezeichnet) der Ausnehmung 92 verbleibt.

### Bezugszeichenliste

- 10: magnetfeldempfindliches Bauelement
- 12: lichte Weite
- 20: Isolator
- 30: Hauptwicklung
- 40: Distanzring
- 50: Abschirmung
- 55: umlaufender Spalt
- 58: Abschirmungsinnenwand
- 60: elektrischer Verbinder
- 70: elektrischer Kontakt
- 75: elektrischer Draht
- 80: Tragplatte
- 90: Verbinderhals
- 92: Ausnehmung
- 94: Kerbe
- 100: Sensor
- 110: elektrischer Leiter / Außenleiter
- 112: Richtung des elektrischen Stroms
- 114: magnetisches Feld
- 116: magnetische Flussdichte
- 120: elektrischer Leiter / Neutralleiter
- 122: Richtung des elektrischen Stroms
- 124: magnetisches Feld
- 126: magnetische Flussdichte
- 130: Zeitachse
- 132: Schwingung der magnetischen Flussdichte
- 134: Asymptote
- 136: Asymptote
- 140: Neigung des fehlerhaften Auslösens
- 142: Verlauf der Neigung des fehlerhaften Auslösens
- 150: kleinster messbarer Differenzstrom
- 152: Verlauf des kleinsten messbaren Differenzstroms
- 160: Optimalwert
- 165: optimaler Bereich

## Patentansprüche

1. Sensor (100) zum allstromsensitiven Bestimmen eines Differenzstroms,
- wobei der Sensor (100) ein magnetfeldempfindliches Bauelement (10), eine erste Hauptwicklung (30), eine Testwicklung und eine Abschirmung (50) aufweist,
- wobei das magnetfeldempfindliche Bauelement (10) ein Bauelement aus einem weichmagnetischen Stoff ist,
- wobei das magnetfeldempfindliche Bauelement (10) eine Durchgangsöffnung aufweist, wobei die Durchgangsöffnung des magnetfeldempfindlichen Bauelements (10) im Querschnitt als ein Oval mit zwei Symmetrieachsen ausgebildet ist,
- wobei die erste Hauptwicklung (30) und die Testwicklung mit jeweils einer Mehrzahl von Windungen das magnetfeldempfindliche Bauelement (10) umschließen,
- wobei die erste Hauptwicklung (30) dazu eingerichtet ist, aktiv mittels einer Stromquelle oder einer Spannungsquelle mit einem elektrischen Strom versorgt zu werden,
- wobei die Abschirmung (50) einen Aufnahmeraum aufweist, welcher zum Aufnehmen des magnetfeldempfindlichen Bauelements (10), der ersten Hauptwicklung (30) und der Testwicklung eingerichtet ist,
- wobei der Aufnahmeraum der Abschirmung (50) in radialer Richtung von einer Abschirmungsaußenwand und einer Abschirmungsinnenwand (58) begrenzt ist,
- wobei die Abschirmungsinnenwand (58) eine Durchgangsöffnung der Abschirmung (50) definiert, wobei die Durchgangsöffnung der Abschirmung (50) als ein Oval mit zwei Symmetrieachsen ausgebildet ist,
- wobei die Abschirmung (50) im Bereich der Abschirmungsinnenwand (58) einen umlaufenden Spalt (55) aufweist,
- wobei der Sensor (100) dazu eingerichtet ist, um zumindest zwei elektrische Leiter (110, 120) herum angeordnet zu werden,
- wobei die Durchgangsöffnung des magnetfeldempfindlichen Bauelements (10) zumindest eine lichte Weite entlang einer Symmetrieachse aufweist,
**dadurch gekennzeichnet, dass**
die zumindest eine lichte Weite in einem Bereich zwischen 25,2 und 32 mm liegt, bevorzugt in einem Bereich zwischen 25,5 und 29 mm und besonders bevorzugt zwischen 25,8 und 27 mm.

2. Sensor (100) nach Anspruch 1, **dadurch gekennzeichnet, dass** das magnetfeldempfindliche Bauelement (10) von einem Isolator (20) ummantelt ist, wobei der Isolator (20) zwischen dem magnetfeldempfindlichen Bauelement (10) und der ersten Hauptwicklung (30) und zwischen dem magnetfeldempfindlichen Bauelement (10) und der Testwicklung angeordnet ist.

3. Sensor (100) nach einem der Ansprüche 1 oder 2, **dadurch gekennzeichnet, dass** der Sensor (100) eine zweite Hauptwicklung (30) aufweist, wobei die zweite Hauptwicklung (30) das magnetfeldempfindliche Bauelement (10) und/oder den Isolator (20) mit einer Mehrzahl von Windungen umschließt.

4. Sensor (100) nach einem der vorstehenden Ansprüche, **dadurch gekennzeichnet, dass** der Sensor (100) einen Distanzring (40) aufweist, wobei der Distanzring (40) zwischen der Abschirmungsinnenwand und der ersten Hauptwicklung (30) angeordnet ist.

5. Sensor (100) nach einem der vorstehenden Ansprüche, **dadurch gekennzeichnet, dass** die Abschirmung (50) eine Beschichtung aufweist, insbesondere eine elektrisch isolierende Beschichtung.

6. Sensor (100) nach einem der vorstehenden Ansprüche, **dadurch gekennzeichnet, dass** die Abschirmung (50) eine Materialdicke in einem Bereich zwischen 0,25 mm und 0,45 mm aufweist, bevorzugt in einem Bereich zwischen 0,3 mm und 0,4 mm und besonders bevorzugt in einem Bereich zwischen 0,32 mm und 0,38 mm.

7. Sensor (100) nach einem der vorstehenden Ansprüche, **dadurch gekennzeichnet, dass** der umlaufende Spalt (55) eine Spaltbreite in einem Bereich zwischen 0,1 mm und 2,0 mm aufweist, bevorzugt in einem Bereich zwischen 0,3 mm und 1,7 mm und besonders bevorzugt in einem Bereich zwischen 0,6 mm und 1,3 mm.

8. Sensor (100) nach einem der vorstehenden Ansprüche, **dadurch gekennzeichnet, dass** der Sensor (100) einen elektrischen Verbinder (60) aufweist, wobei der elektrische Verbinder (60) eine Tragplatte (80), einen Verbinderhals (90) und eine Mehrzahl von elektrischen Kontakten (70) aufweist,
- wobei der elektrische Verbinder (60) zumindest für jede Wicklung zwei elektrische Kontakte (70) aufweist,
- wobei die elektrischen Kontakte (70) in radialer Richtung außerhalb der Abschirmungsaußenwand angeordnet sind,
- wobei die Tragplatte (80) zwischen der Abschirmungsaußenwand und der ersten Hauptwicklung (30) angeordnet ist,
- wobei der Verbinderhals (90) durch eine Öffnung in der Abschirmungsaußenwand verläuft und die Tragplatte (80) und die elektrischen Kontakte (70) miteinander verbindet,
- wobei die Tragplatte (80) und der Verbinderhals (90) jeweils eine korrespondierende Ausnehmung (92) aufweisen, wobei die Ausnehmung (92) dazu eingerichtet ist, die mit jeder Wicklung in einer Wirkverbindung stehenden zwei elektrischen Drähte (75) aus dem Aufnahmeraum aufzunehmen und aus dem Aufnahmeraum durch die Öffnung in der Abschirmungsaußenwand zu den elektrischen Kontakten (70) zu führen,
- wobei die Ausnehmung (92) in einer Richtung parallel zu der Abschirmungsaußenwand eine Kerbe (94) aufweist, durch welche die elektrischen Drähte (75) in einen Zentralbereich der Ausnehmung (92) eingelegt werden können.

9. Schutzschalter zum Unterbrechen eines Stromkreises bei Differenzströmen in dem Stromkreis die einen Grenzwert überschreiten aufweisend einen Sensor (100) nach einem der Ansprüche 1 bis 8, eine Betriebsschaltung, eine elektronische Datenverarbeitungs- und -auswerteeinheit und eine Schaltvorrichtung,
- wobei der Sensor (100) um zumindest zwei elektrische Leiter (110, 120) herum angeordnet ist, die den Stromkreis bilden,
- wobei die Schaltvorrichtung zum Unterbrechen des Stromkreises eingerichtet ist,
- wobei die Betriebsschaltung zum Betrieb des Sensors (100) eingerichtet ist,
- wobei die elektronische Datenverarbeitungs- und -auswerteeinheit zur Auswertung von Sensorsignalen des Sensors (100) eingerichtet ist,
- wobei die elektronische Datenverarbeitungs- und -auswerteeinheit dazu eingerichtet ist, bei Erkennung eines elektrischen Differenzstroms, insbesondere bei allstromsensitiver Erkennung eines Differenzstroms, mit einer Stromstärke größer des Grenzwertes, insbesondere eines einstellbaren Grenzwertes, die Schaltvorrichtung derart anzusteuern, dass die Schaltvorrichtung den Stromkreis unterbricht.

10. Ladekabel zum Laden eines Elektrofahrzeuges, wobei das Ladekabel einen Sensor (100) nach einem der Ansprüche 1 bis 8 oder einen Schutzschalter nach Anspruch 9 aufweist.

11. Ladestation zum Laden von Elektrofahrzeugen, wobei die Ladestation einen Sensor (100) nach einem der Ansprüche 1 bis 8 oder einen Schutzschalter nach Anspruch 9 aufweist.

## Claims

1. Sensor (100) for universal-current-sensitive determination of a residual current,
- the sensor (100) having a magnetic field-sensitive component (10), a first main winding (30), a test winding and a shield (50),
- the magnetic field-sensitive component (10) being a component made of a soft-magnetic material,
- the magnetic field-sensitive component (10) having a through-opening, the through-opening of the magnetic field-sensitive component (10) being formed in cross section as an oval having two axes of symmetry,
- the first main winding (30) and the test winding each surrounding the magnetic field-sensitive component (10) with a plurality of turns,
- the first main winding (30) being designed to be actively supplied with an electric current by means of a current source or a voltage source,
- the shield (50) having a receiving space that is designed to receive the magnetic field-sensitive component (10), the first main winding (30) and the test winding,
- the receiving space of the shield (50) being delimited in the radial direction by a shield outer wall and a shield inner wall (58),
- the shield inner wall (58) defining a through-opening of the shield (50), the through-opening of the shield (50) being formed as an oval having two axes of symmetry,
- the shield (50) having a circumferential gap (55) in the region of the shield inner wall (58),
- the sensor (100) being designed to be arranged around at least two electrical conductors (110, 120),
- the through-opening of the magnetic field-sensitive component (10) having at least one clear width along an axis of symmetry,
**characterized in that**
the at least one clear width is in a range between 25.2 and 32 mm, preferably in a range between 25.5 and 29 mm and particularly preferably between 25.8 and 27 mm.

2. Sensor (100) according to claim 1, **characterized in that** the magnetic field-sensitive component (10) is sheathed by an insulator (20), the insulator (20) being arranged between the magnetic field-sensitive component (10) and the first main winding (30) and between the magnetic field-sensitive component (10) and the test winding.

3. Sensor (100) according to either claim 1 or claim 2, **characterized in that** the sensor (100) has a second main winding (30), the second main winding (30) surrounding the magnetic field-sensitive component (10) and/or the insulator (20) with a plurality of turns.

4. Sensor (100) according to any of the preceding claims, **characterized in that** the sensor (100) has a spacer ring (40), the spacer ring (40) being arranged between the shield inner wall and the first main winding (30).

5. Sensor (100) according to any of the preceding claims, **characterized in that** the shield (50) has a coating, in particular an electrically insulating coating.

6. Sensor (100) according to any of the preceding claims, **characterized in that** the shield (50) has a material thickness in a range between 0.25 mm and 0.45 mm, preferably in a range between 0.3 mm and 0.4 mm and particularly preferably in a range between 0.32 mm and 0.38 mm.

7. Sensor (100) according to any of the preceding claims, **characterized in that** the circumferential gap (55) has a gap width in a range between 0.1 mm and 2.0 mm, preferably in a range between 0.3 mm and 1.7 mm and particularly preferably in a range between 0.6 mm and 1.3 mm.

8. Sensor (100) according to any of the preceding claims, **characterized in that** the sensor (100) has an electrical connector (60), the electrical connector (60) having a support plate (80), a connector neck (90) and a plurality of electrical contacts (70),
- the electrical connector (60) having two electrical contacts (70) at least for each winding,
- the electrical contacts (70) being arranged outside the shield outer wall in the radial direction,
- the support plate (80) being arranged between the shield outer wall and the first main winding (30),
- the connector neck (90) passing through an opening in the shield outer wall and interconnecting the support plate (80) and the electrical contacts (70),
- the support plate (80) and the connector neck (90) each having a corresponding recess (92), the recess (92) being designed to receive the two electrical wires (75), which are in an operative connection with each winding, from the receiving space and to guide said wires from the receiving space through the opening in the shield outer wall to the electrical contacts (70),
- the recess (92) having a notch (94) in a direction parallel to the shield outer wall, through which notch the electrical wires (75) can be inserted into a central region of the recess (92).

9. Circuit breaker for interrupting an electric circuit in the case of residual currents in the electric circuit that exceed a limit value, comprising a sensor (100) according to any of claims 1 to 8, an operating circuit, an electronic data processing and evaluation unit and a switching device,
- wherein the sensor (100) is arranged around at least two electrical conductors (110, 120) that form the electric circuit,
- wherein the switching device is designed to interrupt the electric circuit,
- wherein the operating circuit is designed to operate the sensor (100),
- wherein the electronic data processing and evaluation unit is designed to evaluate sensor signals from the sensor (100),
- wherein the electronic data processing and evaluation unit is designed to actuate the switching device in such a way that the switching device interrupts the electric circuit in the case of detection of an electrical residual current, in particular in the case of universal-current-sensitive detection of a residual current, that has a current strength greater than the limit value, in particular an adjustable limit value.

10. Charging cable for charging an electric vehicle, wherein the charging cable has a sensor (100) according to any of claims 1 to 8 or a circuit breaker according to claim 9.

11. Charging station for charging electric vehicles, wherein the charging station has a sensor (100) according to any of claims 1 to 8 or a circuit breaker according to claim 9.

## Revendications

1. Capteur (100) pour la détermination sensible à tous les courants d'un courant différentiel,
- dans lequel le capteur (100) présente un composant sensible au champ magnétique (10), un premier enroulement principal (30), un enroulement de test et un blindage (50),
- dans lequel le composant sensible au champ magnétique (10) est un composant constitué d'un matériau magnétique doux,
- dans lequel le composant sensible au champ magnétique (10) présente une ouverture traversante, l'ouverture traversante du composant sensible au champ magnétique (10) étant conçue en section transversale comme un ovale comportant deux axes de symétrie,
- dans lequel le premier enroulement principal (30) et l'enroulement de test entourent le composant sensible au champ magnétique (10) avec respectivement une pluralité de spires,
- dans lequel le premier enroulement principal (30) est conçu pour être activement alimenté en courant électrique au moyen d'une source de courant ou d'une source de tension,
- dans lequel le blindage (50) présente un espace de logement conçu pour loger le composant sensible au champ magnétique (10), le premier enroulement principal (30) et l'enroulement de test,
- dans lequel l'espace de logement du blindage (50) est délimité dans la direction radiale par une paroi extérieure de blindage et une paroi intérieure de blindage (58),
- dans lequel la paroi intérieure de blindage (58) définit une ouverture traversante du blindage (50), l'ouverture traversante du blindage (50) étant conçue comme un ovale comportant deux axes de symétrie,
- dans lequel le blindage (50) présente une fente circonférentielle (55) dans la zone de la paroi intérieure de blindage (58), dans lequel le capteur (100) est conçu pour être disposé autour d'au moins deux conducteurs électriques (110, 120),
- dans lequel l'ouverture traversante du composant sensible au champ magnétique (10) présente au moins une largeur libre le long d'un axe de symétrie,
**caractérisé en ce que**
l'au moins une largeur libre se trouve dans une plage comprise entre 25,2 et 32 mm, de préférence dans une plage comprise entre 25,5 et 29 mm et de manière particulièrement préférée entre 25,8 et 27 mm.

2. Capteur (100) selon la revendication 1, **caractérisé en ce que** le composant sensible au champ magnétique (10) est entouré d'un isolant (20), l'isolant (20) étant disposé entre le composant sensible au champ magnétique (10) et le premier enroulement principal (30) et entre le composant sensible au champ magnétique (10) et l'enroulement de test.

3. Capteur (100) selon l'une quelconque des revendications 1 ou 2, **caractérisé en ce que** le capteur (100) présente un second enroulement principal (30), le second enroulement principal (30) entourant le composant sensible au champ magnétique (10) et/ou l'isolant (20) avec une pluralité de spires.

4. Capteur (100) selon l'une quelconque des revendications précédentes, **caractérisé en ce que** le capteur (100) présente une bague d'écartement (40), la bague d'écartement (40) étant disposée entre la paroi intérieure de blindage et le premier enroulement principal (30).

5. Capteur (100) selon l'une quelconque des revendications précédentes, **caractérisé en ce que** le blindage (50) présente un revêtement, en particulier un revêtement électriquement isolant.

6. Capteur (100) selon l'une quelconque des revendications précédentes, **caractérisé en ce que** le blindage (50) présente une épaisseur de matériau dans une plage comprise entre 0,25 mm et 0,45 mm, de préférence dans une plage comprise entre 0,3 mm et 0,4 mm et de manière particulièrement préférée dans une plage comprise entre 0,32 mm et 0,38 mm.

7. Capteur (100) selon l'une quelconque des revendications précédentes, **caractérisé en ce que** la circonférentielle (55) présente une largeur de fente dans une plage comprise entre 0,1 mm et 2,0 mm, de préférence dans une plage comprise entre 0,3 mm et 1,7 mm et de manière particulièrement préférée dans une plage comprise entre 0,6 mm et 1,3 mm.

8. Capteur (100) selon l'une quelconque des revendications précédentes, **caractérisé en ce que** le capteur (100) présente un connecteur électrique (60), le connecteur électrique (60) présentant une plaque de support (80), un col de connecteur (90) et une pluralité de contacts électriques (70),
- dans lequel le connecteur électrique (60) présente au moins deux contacts électriques (70) pour chaque enroulement,
- dans lequel les contacts électriques (70) sont disposés dans la direction radiale à l'extérieur de la paroi extérieure de blindage,
- dans lequel la plaque de support (80) est disposée entre la paroi extérieure de blindage et le premier enroulement principal (30),
- dans lequel le col de connecteur (90) s'étend à travers une ouverture dans la paroi extérieure de blindage et relie la plaque de support (80) et les contacts électriques (70) les uns aux autres,
- dans lequel la plaque de support (80) et le col de connecteur (90) présentent respectivement un évidement (92) correspondant, l'évidement (92) étant conçu pour recevoir les deux fils électriques (75) provenant de l'espace de réception, qui sont en connexion fonctionnelle avec chaque enroulement, et pour les conduire depuis l'espace de réception à travers l'ouverture dans la paroi extérieure de blindage jusqu'aux contacts électriques (70),
- dans lequel l'évidement (92) présente une encoche (94) dans une direction parallèle à la paroi extérieure de blindage, à travers laquelle les fils électriques (75) peuvent être insérés dans une zone centrale de l'évidement (92).

9. Disjoncteur permettant d'interrompre un circuit lorsque des courants différentiels dans le circuit dépassent une valeur limite, présentant un capteur (100) selon l'une quelconque des revendications 1 à 8, un circuit de fonctionnement, une unité électronique de traitement et d'évaluation de données et un dispositif de commutation,
- dans lequel le capteur (100) est disposé autour d'au moins deux conducteurs électriques (110, 120) qui forment le circuit,
- dans lequel le dispositif de commutation est configuré pour interrompre le circuit,
- dans lequel le circuit de fonctionnement est configuré pour faire fonctionner le capteur (100),
- dans lequel l'unité électronique de traitement et d'évaluation de données est configurée pour évaluer des signaux de capteur du capteur (100),
- dans lequel l'unité électronique de traitement et d'évaluation de données est configurée pour actionner le dispositif de commutation de telle manière que le dispositif de commutation interrompt le circuit lors de la détection d'un courant différentiel électrique, en particulier lors de la détection sensible à tous les courants d'un courant différentiel, présentant une intensité de courant supérieure à la valeur limite, en particulier à une valeur limite réglable.

10. Câble de charge permettant de charger un véhicule électrique, dans lequel le câble de charge présente un capteur (100) selon l'une quelconque des revendications 1 à 8 ou un disjoncteur selon la revendication 9.

11. Station de charge permettant de charger des véhicules électriques, dans laquelle la station de charge présente un capteur (100) selon l'une quelconque des revendications 1 à 8 ou un disjoncteur selon la revendication 9.
